# EUROPÄISCHE PATENTSCHRIFT

(11) **EP 1 589 347 B1**
(45) Veröffentlichungstag und Bekanntmachung des Hinweises auf die Patenterteilung: **24.07.2013**
(21) Anmeldenummer: 05008331.0
(22) Anmeldetag: 16.04.2005
(51) Int. Cl.: G01R 33/34, G01R 33/341

(54) **Hochfrequenz-Resonatorsystem mit optimierter Stromverteilung in den Leiterelementen**
High-frequency resonator system with optimised current distribution in the conductor elements
Système de résonateur haute fréquence avec une distribution de courant optimisée dans les éléments conducteurs

(30) Priorität: 24.04.2004 DE 102004020167
(43) Veröffentlichungstag der Anmeldung: 26.10.2005
(73) Patentinhaber: Bruker BioSpin AG, 8117 Fällanden (CH)
(72) Erfinder: Freytag, Nicolas, 8122 Binz (CH); Marek, Daniel, 5103 Möriken (CH)
(74) Vertreter: Kohler Schmid Möbus

(56) Entgegenhaltungen:
- DE-A1- 10 150 131
- DE-A1- 19 733 574
- DE-C1- 10 205 625
- US-A1- 2002 067 167
- US-A1- 2004 032 262
- US-B2- 6 556 013
- US-B2- 6 590 394

## Beschreibung

Die Erfindung betrifft ein Hochfrequenz(=HF)-Resonator-System, insbesondere für einen NMR(=Kernspinresonanz)-Probenkopf, mit mindestens einem HF-Resonator, der mindestens drei jeweils nicht unterbrochene Leiterelemente umfasst, die im HF-Resonator mindestens ein Fenster bilden, wobei nur ein Teil der Leiterelemente das mindestens eine Fenster begrenzt, wobei die Leiterelemente durch elektromagnetische Felder miteinander gekoppelt sind, wobei jedes Leiterelement jeweils eine materialbedingte, entlang des Leiterelements ortsabhängige Grenzstromdichte aufweist, die im Betrieb nicht überschritten werden darf.

### Stand der Technik

Hochfrequenz-Resonator-Systeme dieser Gattung sind beispielsweise aus der US 5 276 398, entsprechend Referenzliteratur [8], bekannt.

Zur Analyse von Probenzusammensetzungen oder zur Strukturbestimmung von Stoffen in Proben werden Kernspinresonanz(=NMR)-Verfahren eingesetzt. Bei diesen NMR-Verfahren ist die Probe einem starken statischen Magnetfeld ausgesetzt, und es werden transversale hochfrequente elektromagnetische Impulse in die Probe eingestrahlt. Dabei kommt es zu einer Wechselwirkung mit den Kernspins des Probenmaterials. Die zeitliche Entwicklung dieser Kernspins der Probe erzeugt wiederum hochfrequente elektromagnetische Felder, welche in der NMR-Apparatur detektiert werden. Aus den detektierten Hochfrequenz (=HF)-Feldern können Informationen über die Eigenschaften der Probe erhalten werden.

Zur Einstrahlung der HF-Impulse in die Probe oder auch zur Detektion der hochfrequenten elektromagnetischen Felder aus der Probe werden HF-Resonator-Systeme eingesetzt. Ein HF-Resonatorsystem besteht aus einem oder mehreren HF-Resonatoren. Der mindestens eine HF-Resonator ist für die NMR-Messung in unmittelbarer Nähe der Probe angeordnet. Das HF-Resonatorsystem ist galvanisch, kapazitiv oder induktiv an eine Sende- bzw. Empfangselektronik der NMR-Apparatur angekoppelt.

Jeder HF-Resonator umfasst typischerweise mehrere ununterbrochene Leiterelemente, die miteinander elektromagnetisch gekoppelt sind, das heisst ein Stromfluss in einem der Leiterelemente geht aufgrund von elektromagnetischer Kopplung mit einem Stromfluss in den übrigen Leiterelementen einher. Die Gesamtheit der Leiterelemente stellt einen HF-Schwingkreis dar, dessen Resonanzfrequenz dem NMR-Experiment (insbesondere der statischen Magnetfeldstärke) angepasst ist.

Um NMR-Signale möglichst rauscharm detektieren zu können, ist es in der NMR bekannt, die Leiterelemente aus Hochtemperatursupraleiter(=HTS)-Material anzufertigen. Solche HF-Resonatoren können den Dokumenten [1] bis [10] entnommen werden. Ein Nachteil dieser Resonatoren aus HTS ist es, dass die maximal handhabbare transversale HF-Magnetfeldstärke (B1-Feldstärke) dieser HF-Resonatoren durch die kritische Stromdichte j_{c} des HTS-Materials begrenzt ist. Je größer die handhabbare HF-Magnetfeldstärke in den HF-Resonatoren, umso kürzer können die von der NMR-Apparatur verwendeten HF-Impulse sein, was die Anregungsbandbreite erhöht.

### Aufgabe der Erfindung

Es ist daher die Aufgabe der vorliegenden Erfindung, HF-Resonator-Systeme vorzustellen, die möglichst große transversale HF-Magnetfeldstärken gestatten, und weiterhin einen weitgehend quadratischen Zusammenhang zwischen eingestrahlter Leistung und Magnetfeldanstieg im HF-Resonator aufweisen; d.h. der Resonator wird im linearen Bereich der Widerstandskennlinie betrieben.

### Kurze Beschreibung der Erfindung

Diese Aufgabe wird erfindungsgemäß bei einem HF-Resonator-System der eingangs vorgestellten Art dadurch gelöst, dass die Eigenresonanzen der einzelnen Leiterelemente und/oder die elektromagnetische Kopplung zwischen den Leiterelementen durch eine geeignete geometrie so gewählt sind, dass bei Anregung des HF-Resonator-Systems die Maximalwerte der Quotientenwerte entlang den einzelnen Leiterelementen für alle Leiterelemente im Wesentlichen gleich sind, wobei diese Quotientenwerte durch den Quotienten aus der in einem Querschnitt der Leiterelemente senkrecht zur Stromrichtung auftretenden mittleren Stromdichte und der jeweiligen örtlichen Grenzstromdichte definiert sind, wobei die Maximalwerte der Quotientenwerte im wesentlichen gleich sind, wenn die Abweichung eines jeden Maximalwerts vom Mittelwert der Maximalwerte der einzelnen Leiterelemente Maximal 25%, vorzugsweise Maximal 10%, beträgt. Anspruch 2 spezifiziert eine alternative Ausführungsform, bei der der HF-Resonator als Birdcage-Resonator ausgebildet ist.

Grundlage der vorliegenden Erfindung ist es, bei einem HF-Resonator die Stromverteilung in den einzelnen Leiterelementen einzustellen, indem die Kopplungen zwischen den einzelnen Leiterelementen des HF-Resonators gezielt gewählt werden. Die Kopplungen können insbesondere durch Wahl der Länge von überlappenden Leiterabschnitten, durch Verlängern von Leiterelementen etwa mittels mäanderförmiger Abschnitte, durch Veränderung des Abstandes von Leiterelementen und/oder durch Verändern des Querschnitts von Leiterelementen eingestellt werden. Um eine geeignete Geometrie eines HF-Resonators mit einer bestimmten Stromverteilung in einem HF-Resonator zu erreichen, kann ein Simulationsprogramm eingesetzt werden, welches die Maxwell-Gleichungen löst und anschließend iterativ die Geometrie der Leiterelemente verändert.

HF-Resonator-Systeme des Standes der Technik berücksichtigen bei der Zusammensetzung der einzelnen Leiterelemente lediglich die Einstellung der gewünschten Resonanzfrequenz eines gesamten HF-Resonators bzw. HF-Resonator-Systems. Dadurch kommt es im Betrieb zu starken relativen Unterschieden in den Stromdichten in den verschiedenen Leiterelementen. Leiterelemente mit einer hohen relativen Stromdichte gelangen bei hohen HF-Magnetfeldstärken schnell in den Bereich ihrer Grenzstromdichte. Die Grenzstromdichte kann etwa durch die kritische Stromdichte j_{c} im Falle eines supraleitenden Leiterelements gegeben sein, oder auch durch einen Übergang zu nicht-linearem Widerstand, oder durch eine bei gegebener Kühlung durch ohmsche Erwärmung erreichte Schmelztemperatur oder Diffusionsaktivierung bei einem normalleitenden Leiterelement. Wird in einem Leiterelement die Grenzstromdichte erreicht, fällt dieses Leiterelement im HF-Resonator typischerweise aus, und das Kopplungsverhalten im HF-Resonator verändert sich. Die Resonanzfrequenz des HF-Resonators wird im Allgemeinen verstimmt, und eventuell wird der HF-Resonator irreversibel zerstört. Dabei bleiben die meisten Leiterelemente weit unterhalb ihrer jeweiligen Grenzstromdichte.

Erfindungsgemäß ausgestaltete HF-Resonatoren weisen eine von zwei Stromverteilungsvarianten auf.

In der ersten Variante, die vorwiegend für Resonatoren auf planaren Substraten erfindungsgemäß einzusetzen ist, wird in jedem Leiterelement der Stromfluss entsprechend der Stromtragfähigkeit dieses Leiterelements eingestellt und so die Stromtragfähigkeit des HF-Resonators insgesamt maximiert. Die maximalen mittleren Stromdichten innerhalb der Leiterelemente im Betrieb sind so eingestellt, dass sich die einzelnen Leiterelemente mit steigender HF-Magnetfeldstärke gleichmäßig ihrer jeweiligen Grenzstromdichte annähern. Dadurch kann die volle Stromtragfähigkeit aller Leiterelemente genutzt werden.

In der zweiten Variante, die vorwiegend für Birdcage-Resonatoren erfindungsgemäß einzusetzen ist, ist im Betrieb im HF-Resonator eine bestimmte relative Stromverteilung in den einzelnen Leiterelementen vorgesehen (=Soll-Stromverteilung), etwa eine sinusoidale Stromverteilung. Diese Soll-Stromverteilung besitzt ein Soll-Strommaximum, etwa im Maximum eines Sinus bei π/2. Im Stand der Technik treten vor allem im Randbereich und an den Fenstern von HF-Resonatoren oder allgemeiner im Randbereich von räumlich separierten Ansammlungen von zusammengehörigen Leiterelementen (=Paketen) innerhalb eines HF-Resonators in einzelnen Leiterelementen oder Gruppen von Leiterelementen Stromflüsse auf, die weit oberhalb des Stromflusses der Leiterelemente des Soll-Strommaximums liegen. Diese randständigen Leiterelemente erreichen ihre Grenzstromdichte bei deutlich niedrigeren HF-Magnetfeldstärken als die Leiterelemente im Bereich des Soll-Strommaximums und begrenzen daher unnötiger Weise die Leistungsfähigkeit des HF-Resonators. Erfindungsgemäß werden nun die Leiterelemente so ausgelegt, dass in keinem Leiterelement der Stromfluss größer ist als im Soll-Strommaximum. Insbesondere kann eine "quasi-stetige" oder glatte Stromverteilung bezüglich benachbarter Leiterelemente eingestellt werden. Dies wird beispielsweise durch eine Verringerung der kapazitiven Kopplung zwischen den betroffenen randständigen Leiterelementen und dem Ring des Birdcage-Resonators und damit eine geringere Stromeinkopplung erreicht. In einem erfindungsgemäßen Resonator kann die volle Stromtragfähigkeit der Leiterelemente im Bereich des Soll-Strommaximums genutzt werden. Im allgemeinen Falle von geometrisch unterschiedlichen Leiterelementen und/oder unterschiedlichen Grenzstromdichten in den einzelnen Leiterelementen ist in der zweiten Variante erfindungsgemäß der Maximalwert der Quotientenwerte eines jeden Leiterelements kleiner oder gleich dem Maximalwert in demjenigen Leiterelement mit dem gemäß Soll-Stromverteilung größten Maximalwert der Quotientenwerte dieses Leiterelements.

In beiden Varianten wird ein Ausfall (etwa Quench) einzelner Leiterelemente bei relativ niedrigen HF-Magnetfeldstärken unterhalb der eigentlichen Leistungsgrenze des HF-Resonators vermieden.

Im Folgenden soll kurz die Bestimmung des Maximalwerts der Quotientenwerte eines Leiterelements erläutert werden: In einem Leiterelement wird im Betrieb an einem ersten Ort (bzgl. z, Koordinate entlang des Leiterelements) ein erster Querschnitt betrachtet. Senkrecht durch diesen Querschnitt fließt räumlich verteilt Strom, d.h. es existieren räumlich verschiedene, lokale Stromdichten j(x, y) (mit x, y: Koordinaten senkrecht zu z). Für die Bestimmung von Stromdichten wird dabei jeweils die Maximalamplitude des betrachteten Wechselstroms zugrunde gelegt, d.h. die zeitliche Entwicklung des betrachteten Wechselstroms innerhalb einer Periode wird außer Betracht gelassen. Nun werden die lokalen Stromdichten über die Querschnittsfläche integriert und somit eine mittlere Stromdichte in dem Querschnitt bestimmt. An dem Ort (bzgl. z) des Querschnitts ist eine örtliche Grenzstromdichte gegeben. Eine Ortsabhängigkeit der Grenzstromdichte entlang z kann sich beispielsweise aufgrund von Anisotropie bezüglich des statischen Magnetfelds ein einem gekrümmten Leiterelement ergeben. Der Quotient aus mittlerer Stromdichte und Grenzstromdichte ergibt den Quotientenwert am Ort des Querschnitts. In gleicher Weise werden für alle Orte (bzgl. z) entlang des Leiterelements Quotientenwerte gebildet. Der höchste Quotientenwert wird als der Maximalwert der Quotientenwerte des Leiterelements bezeichnet. In der Regel wird der höchste Quotientenwert im Bereich eines Symmetriezentrums, insbesondere in der Mitte eines Leiterelements, gefunden.

In einem einfachen Fall besitzen alle Leiterelemente einen identischen Querschnitt und eine einheitliche, räumlich konstante Grenzstromdichte; dann sind die Maximalwerte der Quotientenwerte in den Leiterelementen proportional den maximalen Strömen in den Leiterelementen.

Im Rahmen der vorliegenden Erfindung sind die Maximalwerte der Quotientenwerte dann im Wesentlich gleich, wenn die Abweichung eines jeden Maximalwerts vom Mittelwert der Maximalwerte der einzelnen Leiterelemente maximal 25%, vorzugsweise maximal 10%, beträgt.

Die Maximalwerte der Quotientenwerte entlang der einzelnen Leiterelemente sind erfindungsgemäß weiterhin insbesondere dann im Wesentlichen gleich, wenn der Mittelwert der Maximalwerte der Quotientenwerte wenigstens 75%, vorzugsweise wenigstens 90%, des Maximalwerts der Quotientenwerte desjenigen Leiterelements mit dem größten Maximalwert der Quotientenwerte aller Leiterelemente beträgt. In diesem Fall wird die gesamte Stromtragfähigkeit des HF-Resonator-Systems zu wenigstens 75% bzw. 90% ausgenutzt.

In den Rahmen der vorliegenden Erfindung fällt es auch, wenn wenigstens 75%, vorzugsweise 90%, der Leiterelemente im Wesentlichen gleich große Maximalwerte der Quotientenwerte aufweisen, und die restlichen 25%, vorzugsweise 10%, der Leiterelemente kleinere Maximalwerte der Quotientenwerte aufweisen. Die restlichen Leiterelemente reduzieren in diesem Fall die Auslastung des erfindungsgemäßen Resonator-Systems nur geringfügig.

Für die vorliegende Erfindung werden nur Einzelresonatoren oder Bauteile, die einen merklichen absoluten Beitrag zum B1-Feld liefern bzw. liefern sollen, als Leiterelemente angesehen. Insbesondere werden galvanisch isolierte Plättchen, die lediglich der makroskopischen Homogenisierung des Leitermaterials dienen und nur vergleichsweise geringen Strom tragen, nicht als Leiterelemente im Sinne der Erfindung angesehen.

### Bevorzugte Ausführungsformen

Besonders bevorzugt ist eine Ausführungsform des erfindungsgemäßen HF-Resonator-Systems, bei der die Leiterelemente aus Supraleitermaterial, insbesondere NbTi oder Nb₃Sn, gefertigt sind. Supraleitende Leiterelemente können HF-Ströme verlustarm tragen, so dass das HF-Resonator-System besonders hohe Resonator-Güten erreicht und NMR-Signale mit hohem Signal zu Rauschverhalten detektiert werden können.

Die gleichen Vorteile in stärkerer Ausprägung besitzt eine Weiterbildung dieser Ausführungsform, bei der die Leiterelemente aus Hochtemperatur-Supraleitermaterial (z.B. Tl₂Ba₂CaCu₂O₈, YBa₂Cu₃O₇₋ₓ, (Tl, Pb)Sr₂Ca₂Cu₃O₉, BiPbSrCaCuO, BiSrCaCuO, BiSrCuO oder BiSrYCuO) mit einer Sprungtemperatur > 30 K gefertigt sind.

Eine vorteilhafte Ausführungsform sieht vor, dass die Leiterelemente auf einem ebenen, polyedrischen oder zylinderförmigen, dielektrischen Substrat aufgebracht sind. Das Substrat stabilisiert mechanisch den zughörigen Resonator, und kann als Dielektrikum die Kopplung der Leiterelemente beeinflussen. Außerdem gestattet das Substrat die Ableitung von Wärme, insbesondere bei normalleitenden Leiterelementen, beziehungsweise die Kühlung von supraleitenden Leiterelementen unter die Sprungtemperatur des supraleitenden Materials. Ein Substrat kann erfindungsgemäß auf Ober- und Unterseite mit Leiterelementen versehen sein. Auch können zwei Substrate, die jeweils Leiterelemente aufweisen, aneinander befestigt und/oder miteinander verklebt sein.

Bei einer bevorzugten Ausführungsform des erfindungsgemäßen HF-Resonator-Systems ist vorgesehen, dass die Leiterelemente einen annähernd rechteckförmigen Querschnitt aufweisen, insbesondere mit einer Dicke zwischen 200 nm und 1 µm und/oder einer Breite zwischen 2 µm und 50µm. Der rechteckförmige Querschnitt ist leicht herzustellen und die rechnergestützte Bestimmung von erfindungsgemäßen Geometrien für Leiterelemente ist bei dieser Grundform besonders einfach.

Besonders vorteilhaft sind bei einer Ausführungsform die Grenzstromdichten in allen Leiterelementen eines HF-Resonators gleich groß. Dies kann beispielsweise durch einen geeigneten, einheitlichen, isotropen Werkstoff für alle Leiterelemente erreicht werden.

Vorteilhaft ist weiterhin eine Ausführungsform, bei der die Leiterelemente eines HF-Resonators am Ort ihrer jeweiligen maximalen Quotientenwerte jeweils identische Querschnitte aufweisen. In diesem Fall ist am Ort des maximalen Quotientenwerts die mittlere Stromdichte in jedem Leiterelement proportional zum dortigen Stromfluss, wodurch wiederum die Bestimmung einer erfindungsgemäßen Geometrie von Leiterelementen erleichtert wird.

Besonders bevorzugt wird eine Ausführungsform, bei der ein oder mehrere Leiterelemente einen mäanderförmigen Abschnitt aufweisen, insbesondere wobei der mäanderförmige Abschnitt im Bereich der Basis eines U-förmigen Leiterelements angeordnet ist. Mäanderförmige Abschnitte gestatten die gezielte, vornehmliche Änderung der Induktivität eines einzelnen Leiterelements, beziehungsweise der Stehwelleneigenschaften und damit dessen Resonanzfrequenz.

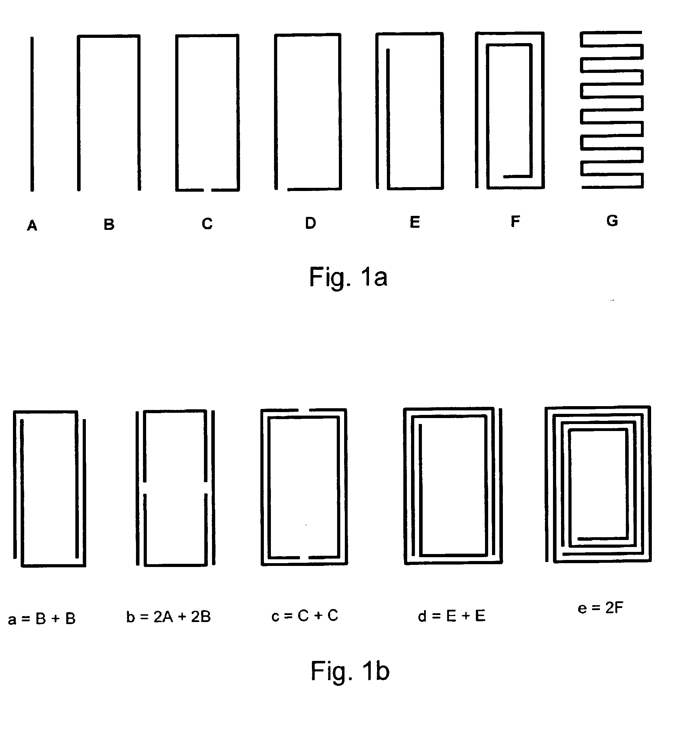

Ebenso besonders bevorzugt wird eine Ausführungsform, bei der verschiedene Leiterpaare unterschiedliche kapazitive Überlappungen besitzen. Leiterpaare werden durch benachbart angeordnete Leiterelemente gebildet. Durch Einstellung von Überlappungslängen an parallel verlaufenden Abschnitten der Leiterelemente mit fixiertem Abstand kann die kapazitive Kopplung zwischen diesen Leiterelementen gezielt eingestellt werden. Eine solche Überlappung kann auch in den beiden Endbereichen eines einzigen Leiterelementes gebildet werden (Fig. 1 a E), bzw. über die gesamte Länge eines Elementes verteilt sein (Fig. 1a: F und G).

Ebenso besonders bevorzugt wird eine Ausführungsform, bei der das Verhältnis zwischen Breite des Leiterelementes und des Abstandes zu benachbarten Leiterelementen im Bereich der Überlappungen für verschiedene Leiterpaare unterschiedlich ist. Breite und Abstand der Leiterelemente können auch unabhängig voneinander bei unterschiedlichen Leiterpaaren erfindungsgemäß unterschiedlich eingestellt sein. Diese Geometrien gestatten eine gezielte Einstellung der Kopplung zwischen den Leiterelementen.

Erfindungsgemäß ist weiterhin ein HF-Resonator-System, das dadurch gekennzeichnet ist, dass der HF-Resonator vier Sets von ineinander geschachtelten U-förmigen Leiterelementen umfasst,
wobei die U-förmigen Leiterelemente eines jeden Sets in eine gleiche Richtung zum Zentrum des HF-Resonators hin geöffnet sind,
dass innerhalb jedes Sets bei weiter außen liegenden U-förmigen Leiterelementen die Enden der Schenkel gegenüber den Enden der Schenkel von weiter innen liegenden U-förmigen Leiterelementen zurückgesetzt sind, dass jeweils zwei Sets mit den Öffnungsrichtungen ihrer U-förmigen Leiterelemente aufeinander zu zeigen und in einer Ebene angeordnet sind,
wobei die U-förmigen Leiterelemente der beiden Sets einer jeden Ebene nicht ineinander greifen,
und wobei die Öffnungsrichtungen der U-förmigen Leiterelemente der ersten Ebene gegenüber den Öffnungsrichtungen der U-förmigen Leiterelemente der zweiten Ebene um 90° gedreht sind.
Dieses HF-Resonator-System weist im Wesentlichen gleiche Maximalwerte der Quotientenwerte für alle Leiterelemente auf.

Bei einer erfindungsgemäßen Ausgestaltung dieses HF-Resonator-Systems sind die beiden Ebenen parallel benachbart angeordnet und durch eine dielektrische Schicht miteinander verbunden.

Erfindungsgemäß ist weiterhin ein HF-Resonator-System, das vorsieht, dass der HF-Resonator zwei Sets von U-förmigen Leiterelementen umfasst, wobei die U-förmigen Leiterelemente jedes Sets jeweils ineinander geschachtelt und in eine gleiche Richtung geöffnet sind,
dass die Öffnungsrichtungen der U-förmigen Leiterelemente der beiden Sets aufeinander zu zeigen,
dass die Schenkel der U-förmigen Leiterelemente der beiden Sets ineinander greifen, wobei in jeden Zwischenraum zwischen zwei benachbarten Schenkeln von Leiterelementen eines Sets genau ein Schenkel eines Leiterelements des anderen Sets eingreift,
und dass die Eingriffstiefe der Schenkel der U-förmigen Leiterelemente in die Zwischenräume im HF-Resonator in einem inneren Bereich, der an das Fenster angrenzt, von innen nach außen abnimmt.
Auch dieses HF-Resonator-System weist im Wesentlichen gleiche Maximalwerte der Quotientenwerte für alle Leiterelemente auf.

Bei einer Ausgestaltung dieses HF-Resonator-Systems nimmt die Eingriffstiefe der Schenkel der U-förmigen Leiterelemente in die Zwischenräume im HF-Resonator in einem äußeren Bereich von innen nach außen wieder zu. Dadurch wird die Stromtragfähigkeit im äußeren Bereich besser in den Resonator eingebunden, insbesondere im Falle von vielen Leiterelementen je Set.

Besonders bevorzugt ist eine Ausführungsform eines erfindungsgemäßen HF-Resonator-Systems, welche mehrere baugleiche HF-Resonatoren, insbesondere 2 oder 4 baugleiche HF-Resonatoren umfasst. Diese Ausführungsform kann als einfache, planare Helmholzanordnung verwendet werden, die besonders gute Feldhomogenität bezüglich B1 aufweist.

Weiterhin erfindungsgemäß ist ein HF-Resonator-System, das vorsieht, dass der HF-Resonator mindestens ein Set von geraden, parallelen Leiterelementen umfasst,
dass in einem mittleren Bereich des Sets die Leiterelemente jeweils gleich lang sind,
und dass in außen liegenden Bereichen des Sets weiter außen liegende Leiterelemente gegenüber weiter innen liegenden Leiterelementen verkürzt sind.
Bei dieser Ausführungsform werden spitzenförmige Stromüberhöhungen im außen liegenden Leiterelementen, also im Randbereich des Sets, eliminiert.
Ein typisches Set ist eine Stange eines Birdcage-Resonators. Ein solches Set stellt auch ein Paket von Leiterelementen im Sinne der Erfindung dar.

Besonders bevorzugt ist weiterhin eine Ausführungsform eines erfindungsgemäßen HF-Resonator-Systems, wobei das HF-Resonator-System Teil eines NMR-Probenkopfes ist und eine zu messende Probe aufweist, wobei die Leiterelemente auf einem oder mehreren ebenen, polyedrischen oder zylinderförmigen, dielektrischen Substraten platziert sind und die räumliche Anordnung der Leiterelemente so gewählt ist, dass das im aktiven Volumen der Probe erzeugte HF-Magnetfeld möglichst homogen ist. Erfindungsgemäß wird also der zu bestimmenden Anordnung der Leiterelemente eine weitere zu optimierende Größe beigegeben, nämlich die Homogenität des zu erzeugenden transversalen HF-Magnetfeldes. In der rechnergestützten Berechnung kann dies dadurch erfolgen, dass zunächst die Bedingungen für den im einfachsten Fall identischen Stromfluss in jedem Leiterelement eingestellt und festgehalten werden, wobei alle Leiterelemente denselben Querschnitt aufweisen sollen. Nun werden die Leiterelemente dergestalt auf den Substraten platziert, dass unter der Bedingung gleicher Maximalströme in allen Leiterelementen eine maximale Feldhomogenität erreicht wird. Zuletzt werden dann die (insbesondere kapazitiven) Kopplungen zwischen den Elementen so eingestellt, dass im Betrieb auch wirklich im Wesentlichen gleich große Maximalströme in den Leiterelementen fließen. Ist dieser kapazitive Stromübertrag zwischen Leiterelementen lokalisiert, dann ist sein Einfluss auf die Feldhomogenität vernachlässigbar. Andernfalls muss ein iterativer Prozess durchlaufen werden. Regelmäßig ist zur Homogenisierung des Feldes außen mehr Stromfluss als innen erforderlich, so dass die Leiterdichte in HF-Resonatoren nach außen hin erfindungsgemäß vergrößert wird.

Vorteilhaft ist weiterhin eine Ausführungsform, bei der benachbarte Leiterelemente an Orten gleichen elektrischen Potentials galvanisch miteinander verbunden sind. Die galvanische Verbindung kann bevorzugt an Symmetriepunkten der Leiterelemente erfolgen. Die Verbindungspunkte können weiterhin zur Einkopplung in oder zur Auskopplung aus einem HF-Resonator verwendet werden.

Eine Ausführungsform sieht vor, dass alle Leiterelemente einen rechteckförmigen Querschnitt mit einheitlicher Breite und einheitlicher Höhe aufweisen, wobei Breite und Höhe senkrecht zur Hauptstromflussrichtung der Leiterelemente verlaufen. Diese Ausführungsform ist besonders einfach herzustellen und zu berechnen.

Eine bevorzugte Ausführungsform, insbesondere für HF-Resonator-Systeme aus Supraleiter, enthält Plättchen, die keinen oder kaum Strom tragen. Diese Plättchen können insbesondere so platziert werden, dass eine makroskopisch homogene Verteilung des Leitermaterials erreicht wird.

Vorteilhaft ist auch eine Ausführungsform des erfindungsgemäßen HF-Resonator-Systems, bei der der HF-Resonator wenigstens 10 Leiterelemente, bevorzugt wenigstens 20 Leiterelemente aufweist. In diesem Fall kann durch die erfindungsgemäße Lehre eine besonders große Leistungsfähigkeit des HF-Resonator-Systems erreicht werden.

Bevorzugt ist auch eine Ausführungsform, bei der die Leiterelemente zumindest teilweise unterschiedliche Eigenresonanzen aufweisen. In diesem Fall kann die Anordnung der Leiterelemente besonders frei gestaltet werden.

Weiterhin bevorzugt ist eine Ausführungsform, bei der die Leiterelemente des HF-Resonators lediglich ineinander geschachtelt sind. Insbesondere sind die Leiterelemente nicht verschachtelt. Ineinander geschachtelt bedeutet, dass weiter innen liegende Leiterelemente vollständig innerhalb eines Bereichs liegen, den weiter außen liegende Leiterelemente umreißen. Anders gesagt stellt sich eine Abfolge von Leiterelementen im Resonator von innen nach außen ein, etwa von einem Fenster wegwärts. Im Falle eines Verschachtelns liegt ein Abschnitt eines ersten Leiterelements zwischen zwei Abschnitten eines zweiten Leiterelements, wobei die beiden Abschnitte des zweiten Leiterelements im Resonator einerseits weiter außen und andererseits weiter innen liegen als der Abschnitt des ersten Leiterelements. Das Ineinander Schachteln erleichtert im Vergleich zum Verschachteln die Einstellung der Stromverteilung in den Leiterelementen und damit im Resonator.

Schließlich ist auch eine Ausführungsform bevorzugt, die dadurch gekennzeichnet ist, dass die Leiterelemente ausschließlich vom linienförmigen Grundtyp und/oder vom U-förmigen Grundtyp und/oder vom offen ringförmigen Grundtyp sind. Diese Grundtypen sind besonders einfach herzustellen und in ein erfindungsgemäßes HF-Resonator-System zu integrieren. Dabei können die Leiterelemente besagter Grundtypen Abwandlungen wie mäanderförmige Abschnitte aufweisen. Alternativ oder zusätzlich kann vorgesehen sein, den HF-Resonator eines erfindungsgemäßen HF-Resonator-Systems frei von Leiterelementen des spiralförmigen Grundtyps auszugestalten. Die Verwendung von einfachen, insbesondere nicht-spiralförmigen Leiterelementen gestattet eine verbesserte Stromauslastung der Leiterelemente.

In den Rahmen der vorliegenden Erfindung fällt auch ein Verfahren zum Design eines erfindungsgemäßen HF-Resonator-Systems mit homogener Stromauslastung nach Anspruch 1, umfassend folgende Schritte:
1. Auslegen eines beliebigen HF-Resonator-Systems, insbesondere gemäß dem Stand der Technik, vorzugsweise gemäß [1-8];
2. Berechnung der Stromverteilung im HF-Resonator-System für die gewünschte Resonanz-Mode;
3. Rechnerische Bestimmung der Maximalwerte Qᵢ der Quotientenwerte entlang der einzelnen Leiterelemente *i*;
4. Korrektur der Eigenresonanzen der einzelnen Leiterelemente und/oder der elektromagnetischen Kopplung durch Anpassen der Längen, und/oder der Verhältnisse zwischen Abstand und Breite der kapazitiven Überlappungen zu benachbarten Leiterelementen, und/oder durch Ersetzen gerader durch mäanderförmige Leiterabschnitte, wobei diese Änderungen proportional zur jeweiligen Abweichung des in Schritt 3 berechneten Wertes *Qᵢ* von einem konstanten Referenzwert erfolgen, wobei der Referenzwert vorzugsweise gleich dem kleinsten, größten oder dem durchschnittlichen Wert der in Schritt 3 berechneten *Qᵢ*-Werte ist;
5. Wiederholen der Schritte 2 bis 4 solange, bis alle Werte *Qᵢ* im Wesentlichen gleich dem gewählten Referenzwert sind und sich ein Hochfrequenz-Resonator-System gemäß Anspruch 1 ergibt.

Weiterhin fällt in den Rahmen der vorliegenden Erfindung ein Verfahren zum Design eines erfindungsgemäßen HF-Resonator-Systems ohne spitzenförmige Stromüberhöhungen nach Anspruch 2, umfassend folgende Schritte:
1. Auslegen eines beliebigen HF-Resonator-Systems, insbesondere gemäß dem Stand der Technik, vorzugsweise gemäß [9-10];
2. Berechnung der Stromverteilung im HF-Resonator-System für die gewünschten Resonanz-Mode;
3. Rechnerische Bestimmung der Maximalwerte *Qᵢ* der Quotientenwerte entlang der einzelnen Leiterelemente *i*;
4. Selektion der Leiterelemente k in den Randbereichen, wo spitzenförmige Stromüberhöhungen auftreten, deren Maximalwerte der Quotientenwerte gleich *Qₖ* sind;
5. Korrektur der Eigenresonanzen der einzelnen Leiterelemente *k* und/oder der elektromagnetischen Kopplung durch Anpassen der Längen, und/oder der Verhältnisse zwischen Abstand und Breite der kapazitiven Überlappungen zu benachbarten Leiterelementen, und/oder durch Ersetzen gerader durch mäanderförmige Leiterabschnitte, wobei diese Änderungen proportional zur jeweiligen Abweichung des in Schritt 3 berechneten Wertes *Qₖ* von einem Referenzwert erfolgen, wobei der Referenzwert kleiner als der größte *Qᵢ*-Wert ausserhalb der selektionierten Randbereiche ist;
6. Wiederholen der Schritte 2 bis 5 solange, bis alle Werte *Qₖ* kleiner oder gleich dem gewählten Referenzwert sind und sich ein Hochfrequenz-Resonator-System gemäß Anspruch 2 ergibt..

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Beschreibung von Ausführungsbeispielen und Zeichnung

Die Erfindung ist in der Zeichnung dargestellt und wird anhand von Ausführungsbeispielen näher erläutert. Es zeigen:
- Fig. 1a: Beispiele für Grundtypen von Leiterelementen (nicht vollständig);
- Fig. 1 b: Beispiele für HF-Resonatoren, die aus den Grundtypen von Leiterelementen gemäß Fig. 1 a zusammengesetzt sind;
- Fig. 2a: einen HF-Resonator mit verteilten Kapazitäten gemäß dem Stand der Technik;
- Fig. 2b: die Stromverteilung im HF-Resonator gemäß Fig. 2a in der Schnittebene II-II';
- Fig. 3a: einen HF-Resonator mit verteilten Kapazitäten mit drei Fingerchen pro Finger gemäß dem Stand der Technik;
- Fig. 3b: die Stromverteilung im HF-Resonator gemäß Fig. 3a in der Schnittebene III-III';
- Fig. 4a-4b: Oberseite und Unterseite eines HF-Resonators auf Basis eines doppelseitig beschichteten Substrats nach dem Stand der Technik;
- Fig. 4c: die Stromverteilung in der Oberseite des HF-Resonators von Fig. 4a/4b in der Schnittebene IV-IV';
- Fig. 5a: einen erfindungsgemäßen HF-Resonator auf Basis ineinander geschachtelter U-förmiger Leiterelemente mit verringerter Überlappung in einem mittleren Bereich;
- Fig. 5b: die Stromverteilung im erfindungsgemäßen HF-Resonator gemäß Fig. 5a entlang der Schnittebene V-V';
- Fig. 6a: einen HF-Resonator des Standes der Technik auf Basis ineinander geschachtelter U-förmiger Leiterelemente mit nach außen hin gleichmäßig zunehmendem Überlappbereich;
- Fig. 6b: die Stromverteilung im HF-Resonator gemäß Fig. 6a entlang der Schnittebene VI-VI';
- Fig. 7a-7b: Oberseite und Unterseite eines erfindungsgemäßen HF-Resonators auf Basis eines doppelseitig beschichteten Substrats mit nach außen offenen, V-artig ausgebildeten Unterbrechungsbereichen zwischen U-förmigen Leiterelementen;
- Fig. 7c: die Stromverteilung im erfindungsgemäßen HF-Resonator gemäß Fig. 7a/7b entlang der Schnittebene VII-VII';
- Fig. 7d: eine überlagerte Darstellung der Oberseite und der Unterseite des erfindungsgemäßen HF-Resonators von Fig. 7a/7b zur Veranschaulichung des Fensters;
- Fig. 8a-8b: Oberseite und Unterseite eines HF-Resonators auf Basis eines doppelseitig beschichteten Substrats mit rechteckförmig ausgebildeten Unterbrechungsbereichen zwischen U-förmigen Leiterelementen nach dem Stand der Technik;
- Fig. 8c: die Stromverteilung im HF-Resonator gemäß Fig. 8a/8b entlang der Schnittebene VIII-VIII';
- Fig. 9a-9b: Oberseite und Unterseite eines erfindungsgemäßen HF-Resonators auf Basis eines doppelseitig beschichteten Substrats mit nach außen offenen, U-artig ausgebildeten Unterbrechungsbereichen zwischen U-förmigen Leiterelementen, wobei die innersten und äußersten Leiterelemente verkürzt sind;
- Fig. 10a: einen erfindungsgemäßer HF-Resonator auf Basis von ineinander geschachtelten U-förmigen Leiterelementen, bei dem an den kurzen Seiten die Breite der Leiterelemente von einem mittleren Bereich der Leiterelemente zum inneren und äußeren Rand des Resonators hin zunimmt;
- Fig. 10b: einen erfindungsgemäßen HF-Resonator auf Basis von ineinander geschachtelten U-förmigen Leiterelementen, bei dem an den kurzen Seiten der Abstand zwischen den Leiterelementen von einem mittleren Bereich der Leiterelemente zum inneren und äußeren Rand hin abnimmt;
- Fig. 10c: einen erfindungsgemäßen HF-Resonator auf Basis von ineinander geschachtelten U-förmigen Leiterelementen, wobei ein Teil der U-förmigen Leiterelemente an ihren Basen mäanderförmige Abschnitte aufweisen;
- Fig. 11 a-11 b: erfindungsgemäße HF-Resonatoren mit galvanischen Verbindungen von einzelnen Leiterelementen;
- Fig. 12a: einen Hybrid-Bridcage-Resonator mit sechs Stangen in perspektivischer Darstellung, zu dem Ausgestaltungen der Stangen in den Figuren 13a/b gemäß der Erfindung und in den Figuren 14a/b gemäß dem Stand der Technik beschrieben sind;
- Fig. 12b: eine Querschnittdarstellung des Hybrid-Birdcage-Resonators von Fig. 12a in der Schnittebene XII-XII', mit Kennzeichnung des Darstellungsbereichs der Stromverteilungen von Fig. 13b/14b;
- Fig. 13a: ein Paket von Leiterelementen (=Stange) eines Hybrid-Birdcage-Resonators wie in Fig. 12a/b gemäß der Erfindung;
- Fig. 13b: die Stromverteilung in vier Paketen von Leiterelementen eines Hybrid-Birdcage-Resonators mit Stangen wie in Fig. 13a gemäß der Erfindung;
- Fig. 14a: ein Paket von Leiterelementen (=Stange) eines Hybrid-Birdcage-Resonators wie in Fig. 12a/b gemäß dem Stand der Technik;
- Fig. 14b: die Stromverteilung in vier Paketen von Leiterelementen eines Hybrid-Birdcage-Resonators mit Stangen wie in Fig. 14a gemäß dem Stand der Technik;
- Fig. 15a-15b: erfindungsgemäße HF-Resonatoren auf Basis geschachtelter U-förmiger Leiterelemente mit nach außen hin abnehmendem Abstand der Leiterelemente zur Verbesserung der Feldhomogenität;
- Fig. 15c: eine Anordnung von planaren Resonatoren, die erfindungsgemäß entsprechend Fig. 15a/15b gestaltet sind;
- Fig. 16a-16b: Oberseite und Unterseite eines erfindungsgemäßen HF-Resonators auf Basis eines doppelseitig beschichteten Substrats mit nach außen offenen, V-artig ausgebildeten Unterbrechungsbereichen zwischen U-förmigen Leiterelementen und galvanischen Verbindungen der U-förmigen Leiterelemente auf Symmetrieebenen.

### a.) Grundsätzliches Design von Resonatoren

Im Bereich der Kernspinresonanz(=NMR)-Probenköpfe sind derzeit entweder Helmholz-/Birdcagespulen aus Normalmetall oder bei Verwendung von supraleitendem Material planare Helmholzspulen bzw. Hybrid-Birdcage-Resonatoren in Gebrauch.

Planare Helmholzspulen werden bislang aus einer geraden Anzahl planarer Resonatoren zusammengesetzt, wobei folgende Resonatortypen verwendet werden:
1. Spiralen (vgl. Grundtyp "e" in Fig. 1b) [1,7,8]
2. Spulen mit verteilten Kapazitäten (vgl. Grundtyp "c" in Fig. 1 b) [3,4]
3. Spulen mit lokalisierten Kapazitäten (vgl. Grundtypen "a", "b", "d" in Fig. 1 b) [2,3,4]
Der erste Resonatortyp hat relativ niedrige Resonanzfrequenzen, eine Variante mit höherer Resonanzfrequenz ist in [1] beschrieben. Der zweite Resonatortyp hat hohe Resonanzfrequzenzen, und der dritte Resonatortyp kann im Gegensatz zum zweiten in z-Richtung den maximalen Strom tragen, da der Abfall in lokalisierten Kapazitäten oben und unten stattfindet, wo im Durchschnitt nur der halbe Strom pro Leiterbahn fließt.

Jeder dieser Resonatortypen kann als aus einer Anzahl N (*N* ≥ 1) von Leiterelementen *i* zusammengesetzt beschrieben werden. Als Leiterelement sei hier ein zusammenhängendes Stück Leiterbahn definiert, das selbst auch als ein Resonator aufgefasst werden kann. Jedes dieser Leiterelemente hat eine bestimmte Resonanzfrequenz *fᵢ*, die durch die verteilten Kapazitäten (z.B. bei Elementen vom Typ E) und Induktivitäten gegeben ist beziehungsweise bei fehlender oder sehr geringer kapazitiver Kopplung zwischen den beiden Endbereichen des Elementes (z.B. bei Elementen vom Typ A, B, C, D aber auch F und G) durch die Stehwelle auf der Länge des Elementes.

Beim Zusammensetzen der Leiterelemente zu einem HF-Resonator bildet sich eine Vielzahl von Moden des Gesamtresonators. Hierbei sind die Resonanzfrequenzen dieses Gesamtresonators durch die Resonanzfrequenzen der einzelnen Leiterelemente sowie die Kopplungen (induktive und kapazitive) zwischen den Leiterelementen gegeben.

Als Beispiel sind in der **Fig. 1a** verschiedene Grundtypen von Leiterelementen (=Grundelemente) gezeigt. Im Stand der Technik werden vor allem Leiterelemente der Grundtypen gerade Line A, U-förmig B, offene Ringe C, D und Spirale F verwendet. Ein im Rahmen der Erfindung erkannter Grundtyp ist der Mäander G. Die Grundelemente können zusammengesetzt werden wie in **Fig. 1b** beispielhaft dargestellt, etwa (B + B) oder (2A + 2B) oder (E + E) usw. Hierbei ist jegliche Form von Skalierung und Drehung aller Grundelemente, sowie Verrundungen von Ecken und geraden Teilstücken möglich.

Gemäß des Standes der Technik geschieht die Zusammensetzung der Leiterelemente mit einer einzigen Randbedingung: die Grundfrequenz des resultierenden Resonators soll gezielt eingestellt werden.

Im Rahmen der Erfindung wurde jedoch erkannt, dass es zwei weitere Randbedingungen, die für NMR-Spulen und insbesondere HTS-Spulen auf planaren und polyedrischen Substraten wichtig sind, gibt:
1. Die maximalen Ströme in jedem Leiterelement;
2. Die Homogenität des resultierenden B1-Feldes.

Ein Supraleiter trägt Strom nur bis zur kritischen Stromdichte j_{c} mit geringem Widerstand. NMR-Spulen sollen transversale B-Felder mit maximaler Stärke erzeugen, um möglichst kurze Pulse zu gestatten. Hierbei ist es folglich wichtig, den maximal möglichen Strom im Resonator zu haben, was bedeutet, dass alle Leiterelemente den selben maximalen Strom tragen sollen (Dies gilt allerdings unter der vereinfachenden Annahme einer gleichen Stromtragfähigkeit aller Leiterelemente; sind unterschiedliche Stromtragfähigkeiten in verschiedenen Leiterelementen gegeben, so soll der Quotient aus maximalem Strom im Leiterelement und Stromtragfähigkeit des Leiterelements für alle Leiterelemente im Wesentlichen gleich sein. Sind sogar die Stromtragfähigkeiten entlang eines einzelnen Leiterelements variabel, so muss auf die Maximalwerte der Quotientenwerte abgestellt werden, vgl. oben). Beginnen nämlich einzelne Leiterelemente einen höheren maximalen Strom als den kritischen Strom tragen zu müssen, dann quencht der Supraleiter lokal. Dies führt in der Regel zum Verstimmen der Resonanzfrequenz des Gesamtresonators und einer deutlichen Verschlechterung der HF-Anpassung, wodurch es unmöglich wird, höhere Ströme im Resonator zu induzieren. Dies kann auch schon bei Strömen deutlich unterhalb eines Quenches auftreten, wenn der HF-Widerstand des Supraleiters beginnt anzusteigen (nichtlineare I-U-Kennlinie / Widerstandskennlinie des Supraleiters). In diesem Falle soll die Stromdichte, bei deren Überschreiten Nichtlinearitäten auftreten, als Grenzstromdichte aufgefasst werden. Des Weiteren liegen deutlich niedrigere Spannungen über den Kapazitäten des Resonators an, wenn dieselbe transversale B-Feldstärke mit einem Resonator mit optimierter Stromverteilung anstatt eines Resonators mit deutlich höheren Strömen in einzelnen Leiterelementen erzeugt wird. Dadurch kann auch Spannungsdurchschlägen vorgebeugt werden.

Das Abstellen auf den maximalen Strom im Leiterelement erfolgt in Hinblick darauf, dass innerhalb eines Leiterelements Strommaxima und Spannungsmaxima unterschiedlicher Stärke abwechseln; für die Bestimmung des maximal möglichen Stroms in einem Leiterelement ist das globale Strommaximum im Leiterelement heranzuziehen (Variiert die Stromtragfähigkeit auch entlang eines Leiterelements, so ist der maximale Quotientenwert aus Strom, d.h. mittlerer Stromdichte, und Stromtragfähigkeit, d.h. Grenzstromdichte, für jedes Leiterelement heranzuziehen und auf einen im Wesentlichen gleichen Wert einzustellen, vgl. wiederum oben).

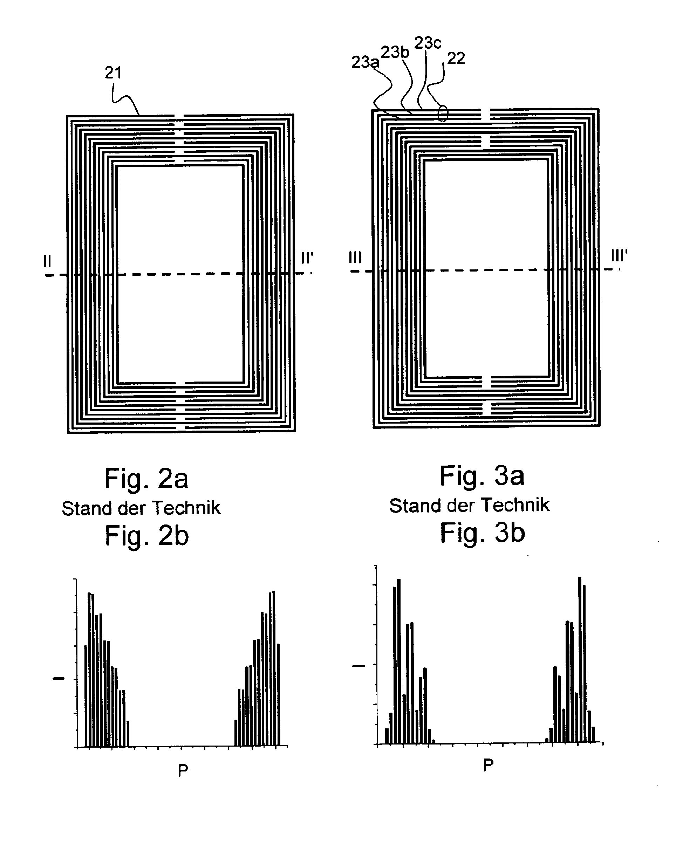

Bei den gemäß des Standes der Technik realisierten Resonatoren (Figuren 2a bis 4c) ist eine homogene Stromverteilung nicht verwirklicht.
Beispielhaft dargestellt ist dazu in **Fig. 2a** ein Resonator mit verteilten Kapazitäten, der aus einer Vielzahl von Resonatoren (Leiterelemente) 21 vom Typ C von Fig. 1 a zusammengesetzt ist. **Fig. 2b** zeigt den durch die einzelnen Leiterelemente fließenden maximalen Strom, wie er in der Schnittebene II-II' von Fig. 2a vorliegt. Nach oben aufgetragen ist der temporelle Maximalwert des Betrages (=Maximal-Amplitude) des Wechsel-Stromflusses "I" in einer geschnittenen Leiterbahn in willkürlichen Einheiten (mit der Rechtswertachse als Null-Linie), nach rechts aufgetragen ist die Position "P" der jeweiligen Leiterbahn auf der Schnittebene II-II'. Der Strom fließt vor allem auf der Außenseite des Resonators. Bei steigendem Gesamtstrom werden außen liegende Leiterelemente quenchen, während innere Leiterbahnen noch weit unterhalb ihrer Stromtragfähigkeit bleiben.

Falls jeder Finger 22 noch in "Fingerchen" 23a-23c unterteilt wird, vgl. **Fig. 3a****,** fließt hauptsächlich Strom auf den beiden äußersten der Fingerchen eines Fingers, vgl. **Fig. 3b**, und die Stromverteilung bei einem Schnitt durch den Resonator (aus Gründen der Vereinfachung seien Schnitte immer auf einer Symmetrieachse, wo maximale Ströme auftreten) hat ein starkes Maximum nach außen hin. Dabei sinkt der maximale Strom, der durch den Resonator getragen werden kann, gegenüber der Ausführungsform von Fig. 2a ab. Als Fingerchen eines Fingers werden gleichartige, parallel ausgerichtete, benachbarte Leiterelemente verstanden; die Gesamtheit dieser Fingerchen wird als Finger bezeichnet.

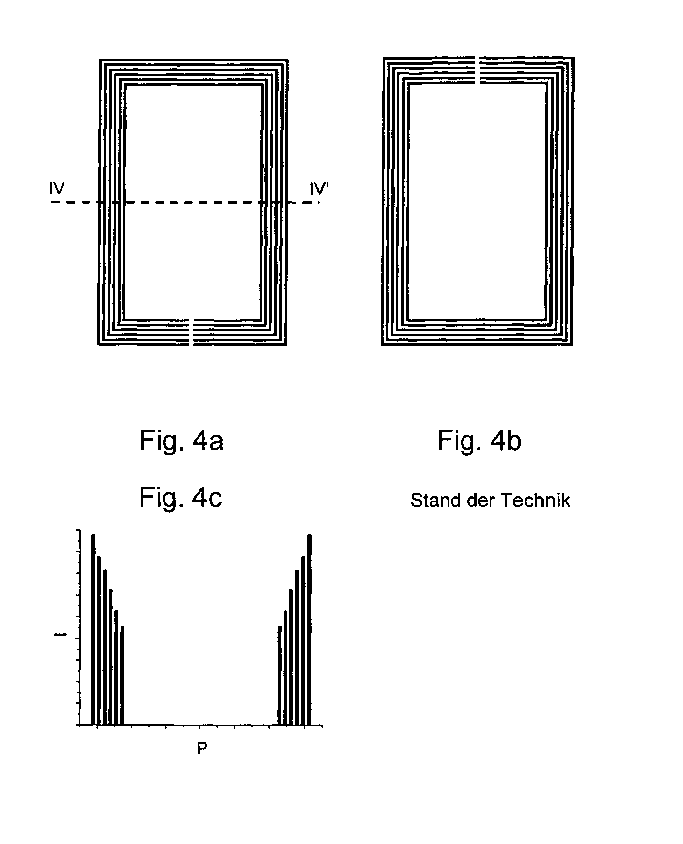

Eine Variante eines Resonators mit verteilten Kapazitäten ist eine Spule auf doppelseitig beschichtetem Substrat, die ein ähnliches Verhalten zeigt wie der Resonator gemäß Fig. 2a. **Fig. 4a** und **Fig. 4b** stellen Ober- und Unterseite eines beidseitig mit HTS-Material beschichteten Substrates dar (bzw. zwei Substrate, die mittels Dielektrikum aufeinandergelegt werden). Der Stromfluss erfolgt wiederum vorwiegend im Außenbereich (**Fig. 4c**); die inneren Leiterelemente werden nicht ausgelastet.

### b.) Erfindungsgemäße Ausgestaltungen von Resonatoren

Die Erfindung besteht nun in ihrer ersten Variante darin, durch Anpassen der Leiterelemente und ihrer Kopplungen den Strom so über den Resonator zu verteilen, dass die Stromverteilung homogen ist, d. h. der maximale Strom in jedem Leiterelement ist gleich groß, und gegebenenfalls auch dass die Stromverteilung im Resonator so definiert ist, dass das dadurch erzeugte magnetische Feld B1 möglichst homogen wird. Eine Kombination der beiden Lösungen ist eine Gleichverteilung der Maximalströme bei einer geometrischen Verteilung der Leiterelemente, die die Homogenität des erzeugten HF-Feldes im Bereich der NMR-Probe optimiert.

Ein aus den Grundelemententen zusammengesetzter HF-Resonator besteht eigentlich aus sehr vielen kapazitiv und induktiv gekoppelten Einzelresonatoren (=Leiterelementen).

Die Stromverteilung kann wunschgemäss eingestellt werden, indem die Eigenfrequenzen der Einzelresonatoren (durch Anpassen der Stehwelleneigenschaften bzw. der Induktivitäten und kapazitiven Kopplung zwischen den Endbereichen der Leiterelemente) sowie die kapazitiven und induktiven Kopplungen zwischen den Einzelresonatoren angepasst werden. Es soll von diesen Methoden insbesondere diejenige (bevorzugte) gezeigt werden, bei der hauptsächlich die kapazitiven Kopplungen verändert werden um den Strom z.B. homogen zu verteilen.

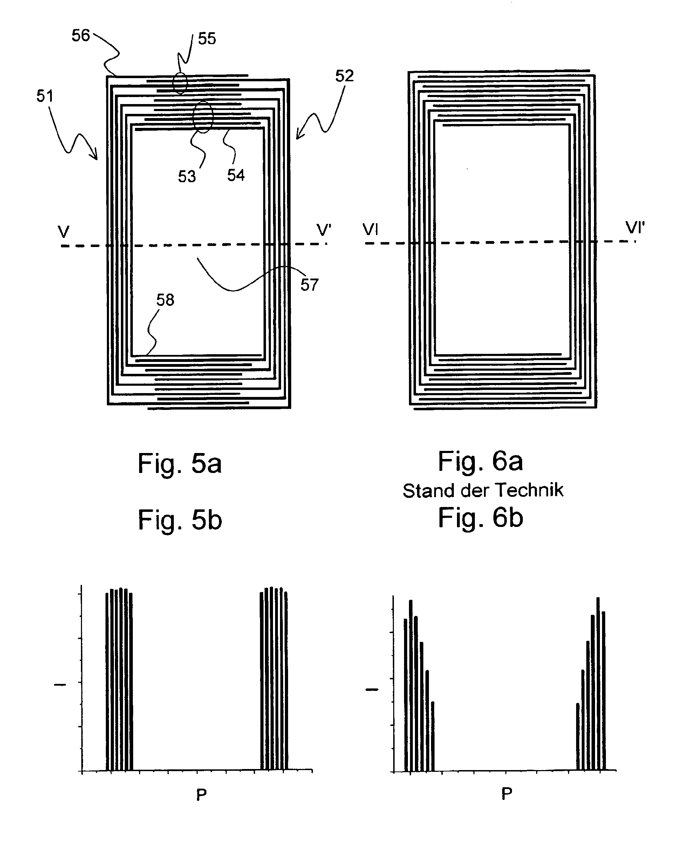

Dazu zeigen die Figuren 5a und 6a jeweils HF-Resonatoren auf Basis ineinandergeschachtelter U-förmiger Leiterelemente. Die erfindungsgemäße Ausführungsform eines Resonators gemäß **Fig. 5a** weist zwei Sets 51, 52 von U-förmigen Leiterelementen auf. Die Leiterelemente eines jeweiligen Sets 51, 52 sind parallel ausgerichtet. Die Schenkel der Leiterelemente der beiden Sets 51, 52 zeigen aufeinander zu und greifen ineinander ein, so dass ein Schenkel des einen Sets jeweils zwischen zwei Schenkel des anderen Sets greift, mit Ausnahmen am inneren und äußeren Rand. Ein Teil der Leiterelemente, nämlich die Leiterelemente 54 und 58 am inneren Rand des Resonators, begrenzen ein im Zentrum des Resonators liegendes Fenster 57. In einem inneren Bereich 53 der Leiterelemente, der sich vom innersten Leiterelement 54 einige Leiterelemente nach außen erstreckt, nimmt die gegenseitige Eingriffstiefe der Leiterelemente von innen nach außen hin ab. In einem äußeren Bereich 55, der sich von einem äußersten Leiterelement 56 einige Leiterelemente nach innen erstreckt, nimmt die gegenseitige Eingrifftiefe von außen nach innen hin ab. Im Stand der Technik hingegen, siehe **Fig. 6a**, erstrecken sich die Schenkel der U-förmigen Leiterelemente gemäß dem Raumangebot zwischen den umgebenden Schenkeln im Wesentlichen bis zur jeweils gegenüberliegenden Basis. In anderen Ausführungsformen des Standes der Technik sind alle Schenkel gleich lang [2-8].

In der erfindungsgemäßen Ausführungsform von Fig. 5a sind die Schenkellängen der Leiterelemente mit bestimmten Längen gewählt, um den Stromfluss in den Leiterelementen zu nivellieren. Der Stromfluss durch die Leiterbahnen in der mittigen Schnittebene V-V', wo in diesem Fall auch die maximalen Ströme in jedem Leiterelement auftreten, ist in **Fig. 5b** dargestellt. Alle Stromstärkewerte in Fig. 5b sind innerhalb von ca. 5% Abweichung gleich. Im Stand der Technik von Fig. 6a treten die jeweils maximalen Ströme in der Symmetrieebene VI-VI' auf. Die zugehörige Stromverteilung, vgl. **Fig. 6b**, zeigt ein Maximum beim zweitäußersten Leiterelement und einen starken Abfall der maximalen Ströme zu den innengelegenen Leiterelementen hin. Das innerste Leiterelement zeigt dabei etwa einen Stromstärkewert von 40% des maximalen Stromstärkewerts des zweitäußersten Leiterelements.

Leiterelemente, die in der Ausführungsform des Standes der Technik von Fig. 6b zu wenig Stromfluss hatten, haben eine zu diesem Defizit grob proportional längere Schenkellänge bzw. Eingriffstiefe (entsprechend größerer kapazitiver Kopplung) in der Ausführungsform von Fig. 5a als das zweitäußerste Leiterelement, welches den maximalen Stromfluss in Fig. 6b hatte.

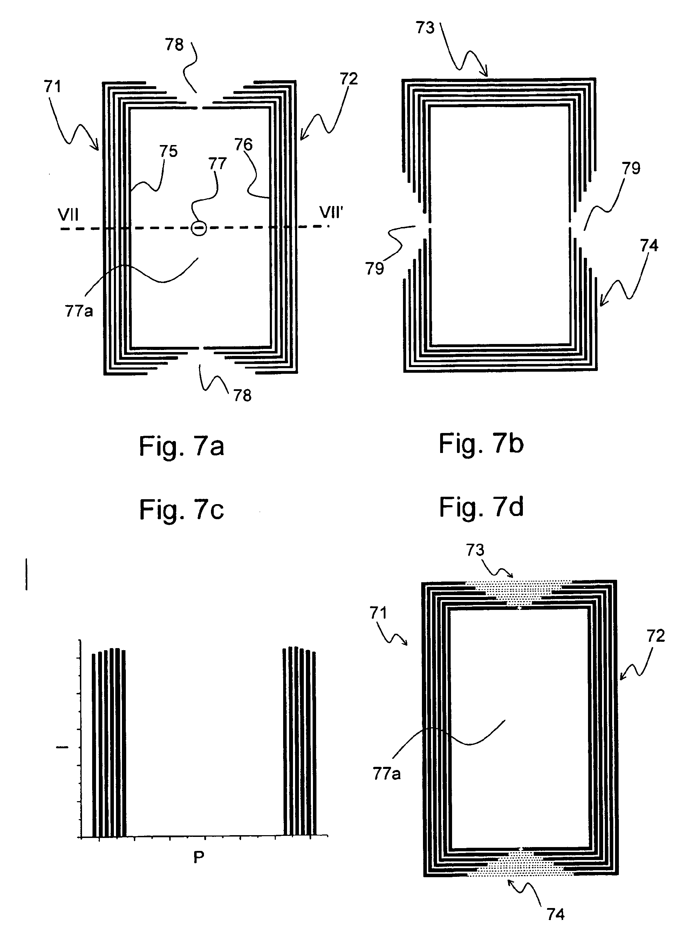

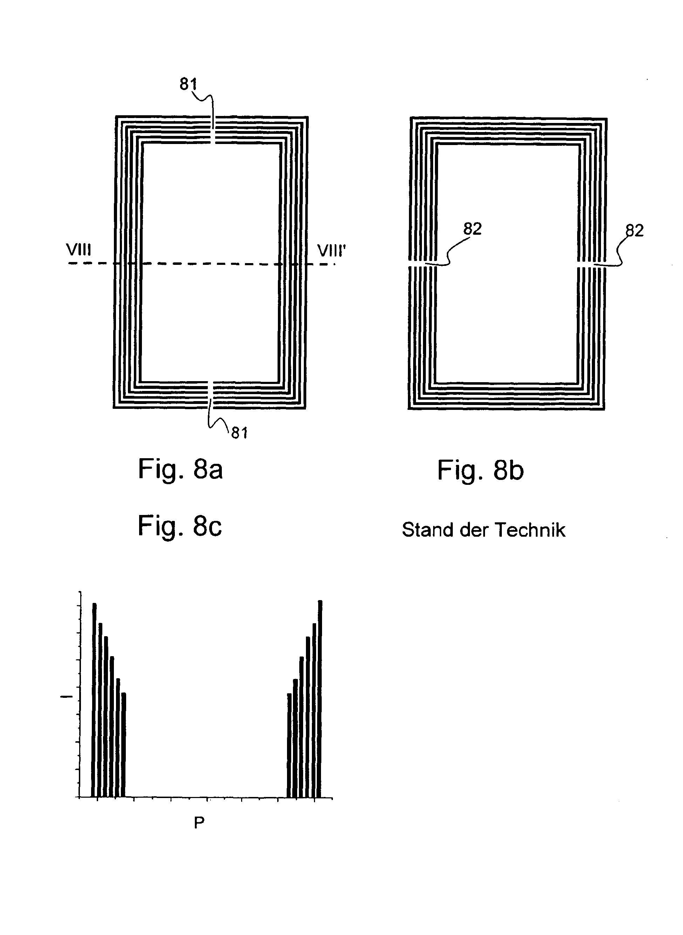

Dieses Prinzip funktioniert auch bei den anderen Typen von Resonatoren. Als weiteres Beispiel wird ein beidseitiger Resonator gezeigt (Summe der Ströme auf beiden Seiten ist überall konstant) - in den Figuren 7a bis 7c gemäss der Erfindung, in den Figuren 8a bis 8c gemäß Stand der Technik:

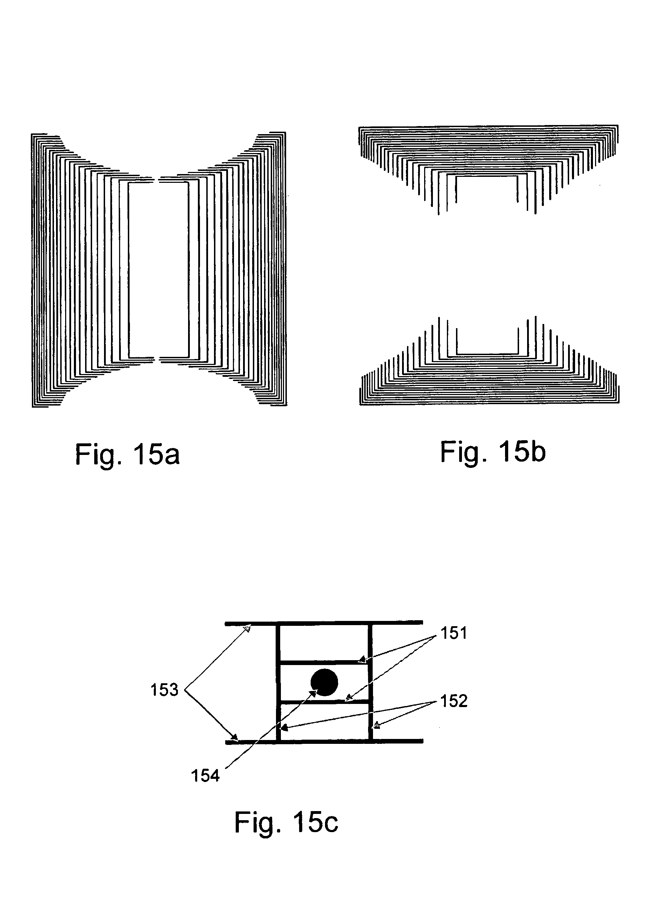

Der Resonator gemäß der Erfindung, vgl. **Fig. 7a, 7b****,** besteht aus vier Sets 71-74 von innerhalb eines Sets parallel ausgerichteten, U-förmigen Leiterelementen, wobei die Sets 71, 72 auf der Oberseite eines Substrats in einer ersten Ebene und die Sets 73, 74 auf der Unterseite des Substrats auf einer zweiten Ebene angeordnet sind. Die Schenkel der Leiterelemente der beiden Sets einer Ebene zeigen aufeinander zu. Die Öffnungsrichtungen der Schenkel der Leiterelemente von Oberseite und Unterseite sind gegeneinander um 90° rotiert. Die innersten Leiterelemente 75, 76 umschließen und begrenzen rechteckförmig ein Fenster 77a des Resonators, beispielhaft gezeigt für die Oberseite in Fig. 7a. Im Bereich des Fensters 77a, bevorzugt im Bereich eines Zentrums 77 ist die zu messende Probe anzuordnen. Bei einem Resonatorsystem, bestehend aus mindestens einem Resonatorpaar ist die Probe bevorzugt im Zentrum des Raumes zwischen den mindestens zwei Resonatoren im Bereich des Fensters angeordnet (siehe Fig. 15c). Zwischen den Enden der gegenüberliegenden Schenkel der Leiterelemente einer Ebene bleiben jeweils dreieckförmige Freiräume 78, 79. Dabei sind die Enden von weiter außen gelegenen Schenkeln in Schenkelrichtung weiter beabstandet als Enden von weiter innen liegenden Schenkeln. Die Stromverteilung in der Symmetrieebene VII-VII', wo die maximalen Ströme auftreten, ist in **Fig. 7c** dargestellt. Der Stromfluss ist im Wesentlichen in allen Leiterelementen gleich. In **Fig. 7d** ist zur Illustration des Bereichs des Fensters 77a eine Überlagerung der Sets 71 bis 74 in der Substratebene gezeigt. Die Sets 73, 74 von Leiterelementen der Unterseite sind nur gestrichelt eingezeichnet und werden größtenteils von den Sets 71, 72 der Oberseite überdeckt.

Im Stand der Technik, vgl. **Fig. 8a, 8b**, sind die Abstände zwischen gegenüberliegenden Schenkeln von U-förmigen Leiterelementen einer Ebene überall gleich groß, dementsprechend sind die zugehörigen Freiräume 81, 82 rechteckförmig. Der maximale Stromfluss in den Leiterelementen ist von außen nach innen abnehmend, siehe **Fig. 8c**.

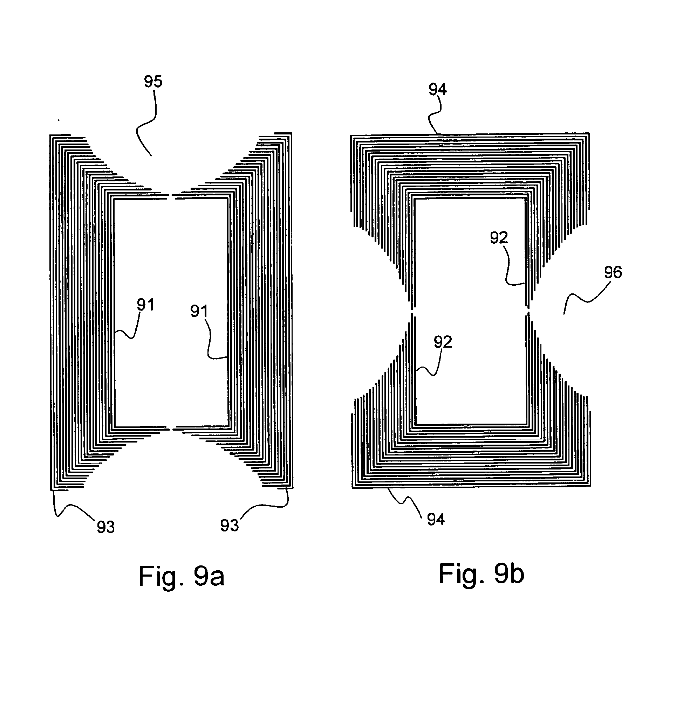

Eine Ausführungsform eines erfindungsgemäßen HF-Resonators entsprechend Fig. 7a, 7b, jedoch mit deutlich mehr Leiterelementen ist in den **Figuren 9a, 9b** dargestellt. Die Maximalströme sind hier in allen Leiterbahnen im Wesentlichen gleich groß. Am Rand ist jeweils ein Leiterelement gekürzt, um die "spitzenförmige Stromüberhöhung" zu beschneiden, vergleichbar wie beim Birdcage, siehe dazu weiter unten. Betroffen ist das jeweils innerste, an das Fenster angrenzende Leiterelement 91, 92 sowie das äußerste Leiterelement 93, 94. Bei noch mehr Elementen kann auch mehr als ein Leiterelement zu kürzen sein. Die Freiräume 95, 96 fallen hier grob U-förmig oder halbkreisförmig aus.

Im Rahmen der vorliegenden Erfindung können etwaige Knicke in Leiterelementen, etwa an rechtwinklig aneinander anschließenden Leiterabschnitten eines Leiterelements, abgerundet ausgebildet sein. Des Weiteren können auch gerade Abschnitte von Leiterelementen durch rund ausgebildete Abschnitte ersetzt sein.

### c.) Erläuterung der Bestimmung einer erfindungsgemäßen Leiterelement-Geometrie

Das Verfahren das zur Bestimmung der Elemente angewandt wird ist Folgendes: Es wird ein Resonator oder Resonator-System zunächst willkürlich, z.B. gemäss Fig. 8a/8b, ausgelegt. Dann wird die Stromverteilung für die relevante Resonanzmode berechnet. Aus dieser werden die Korrekturen für die kapazitiven Kopplungen bestimmt. D.h. die Differenz zwischen einem Referenzwert und der tatsächlichen maximalen Stromdichte wird bestimmt und die Kapazitäten der Leiterelemente mit zu niedrigen Strömen proportional zu dieser Differenz erhöht, derer mit zu hohen Strömen entsprechend erniedrigt (Im Falle ungleicher Leiterquerschnitte oder unterschiedlicher Grenzstromdichten werden entsprechend die Quotientenwerte und nicht die Absolutwerte der Ströme in der Anpassung verwendet). Soll eine homogene Stromverteilung erreicht werden, dann ist dieser Referenzwert für alle Leiterelemente derselbe. Sollen spitzenförmige Stromüberhöhungen in Randbereichen eliminiert werden, dann kann jedem Leiterelement im Randbereich ein Referenzwert zugeordnet werden, der kleiner als der globale Maximalwert (Soll-Strommaximum) der restlichen Leiterelemente ist. Die Referenzwerte können so gewählt werden, dass jede beliebige Stromverteilung eingestellt werden kann, insbesondere die Soll-Stromverteilung, die maximale Feld-Homogenität für ein gegebenes Resonator-System erzielt. Bei der Anpassung der elektromagnetischen Kopplungen und Eigenresonanzen der Leiterelemente ist darauf zu achten, dass die Resonanzfrequenz der betrachteten Resonanzmode bei der richtigen Frequenz verbleibt. Dies wird im Falle homogener Stromverteilung näherungsweise dann erreicht, wenn als Referenzwert zur Anpassung der Stromdichten der Mittelwert der Maximalströme verwendet wird. Schließlich wird die Stromverteilung erneut berechnet. In der Regel benötigt man weniger als fünf Iterationen um in allen Leiterelementen weniger als 5% Abweichungen vom mittleren Strom zu haben und die Resonanzfrequenz einzustellen. Bei Anpassen der Induktivitäten gilt das Verfahren natürlich ebenso.

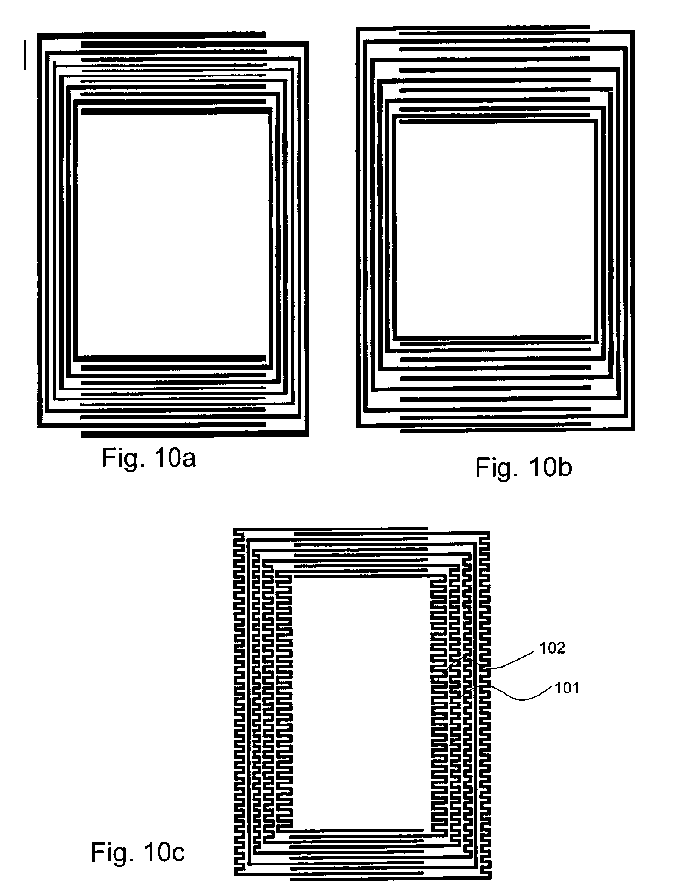

Grundsätzlich stehen erfindungsgemäß mehrere Wege offen, um in einem Leiterelement die Stromdichte anzupassen: Die kapazitiven Kopplungen zwischen den Leiterelementen können entweder durch Veränderung der Länge der Finger in den Fingerkondensatoren (vgl. Fig. 5a, 5b, 7a, 7b) oder durch Ändern der Breite der Finger bei gleichem Abstand (vgl. **Fig. 10a**) oder des Abstandes bei gleicher Fingerbreite (vgl. **Fig. 10b**) oder durch jede Kombination aus diesen drei Möglichkeiten angepasst werden.

Die Stromverteilung lässt sich ebenfalls durch Anpassen der Induktivitäten der einzelnen Leiterbahnen homogenisieren bzw. wunschgemäss einstellen. Eine Erhöhung der Induktivität kann z.B. durch Vergrößern einzelner Schlaufen erreicht werden. Eine weitere Möglichkeit zur Vergrößerung der Induktivität kann durch lokale Mäander (d.h. mäanderförmige Abschnitte 101, 102) entweder innerhalb der Fingerkondensatoren oder außerhalb, vgl. **Fig. 10c**, der Fingerkondensatoren oder eine Kombination der beiden erfolgen.

### d.) Einbringen von galvanischen Verbindungen

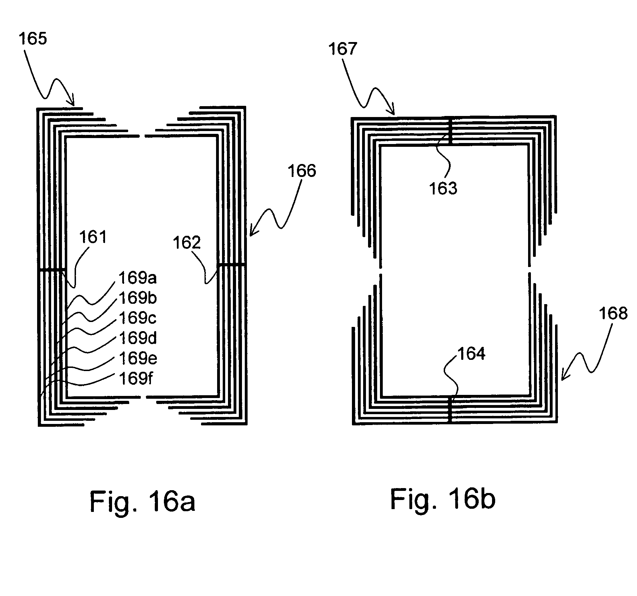

Grundsätzlich ist es im Rahmen der vorliegenden Erfindung möglich, einzelne Leiterelemente an ausgewählten Punkten miteinander galvanisch zu verbinden. Soll dabei die Stromverteilung nicht verändert werden sind geeignete Verbindungspunkte zum Beispiel Orte gleichen elektrischen Potentials im Betrieb des Resonators. Solche Orte gleichen elektrischen Potentials finden sich regelmäßig auf Symmetrieebenen von Resonatoren. Werden in einem Resonator die Ströme homogenisiert und eine galvanischer Verbindung der Elemente an Orten gleichen Potentials durchgeführt, so ändert sich die Stromverteilung nur unwesentlich (abhängig von der Breite der Verbindung). So kann beispielsweise der Resonator von Fig. 7a, 7b erfindungsgemäß vier Verbindungselemente 161-164 jeweils in der Mitte der Sets 165-168 aufweisen, wie in **Fig. 16a** und **Fig. 16b** dargestellt ist. Das Verbindungselement 161 verbindet beispielsweise die sechs paarweise benachbarten Leiterelemente 169a-169f.

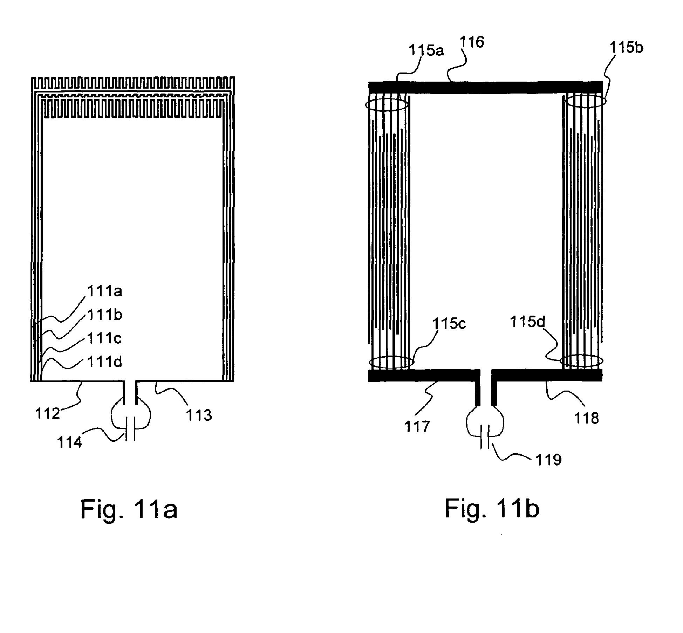

Weitere Ausführungsformen mit galvanischen Verbindungen einzelner Elemente sind in den Figuren 11 a und 11 b dargestellt. Bei diesen Verbindungen handelt es sich nicht um Verbindungen in Symmetrieebenen, wodurch die Verteilung der Ströme wesentlich von der galvanischen Kopplung abhängt. Die Kapazitäten und Induktivitäten der Leiterelemente sowie ihre Kopplungen mit anderen Elementen müssen in diesem Fall unter der Rahmenbedingung einer galvanischen Kopplung angepasst werden.

**Fig. 11a** zeigt einen erfindungsgemäßen Resonator mit vier Leiterelementen 111a-111d. Das Leiterelement 111 b ist U-förmig, während die Leiterelemente 111 a, 111 c und 111 d U-förmig mit Mäanderstrukturen an der Basis sind. Die Mäanderstrukturen dienen der Anpassung des Stromes in den Leiterelementen 111a-111d. Mäanderstrukturen können grundsätzlich auch alternativ oder zusätzlich an den Schenkeln vorgesehen sein. Die linksseitigen Schenkel der Leiterelemente 111 a-111 d sind an ihren Enden mit einem ersten Verbindungselement 112 verbunden, und die rechtsseitigen Schenkel sind an ihren Enden mit einem zweiten Verbindungselement 113 verbunden. Resonanzfrequenz dieses Resonators wird durch eine feste oder variable Kapazität 114 in Form eines Chips oder Trimmers zwischen den als Anschlussbeinen dienenden Elementen 112, 113 eingestellt. Die Stromverteilung ist hierbei über einen weiten Frequenzbereich weitestgehend homogen.

**Fig. 11b** zeigt einen erfindungsgemäßen Resonator mit insgesamt 24 Leiterelementen. Die Sets 115a und 115b von Leiterelementen sind mit einem Verbindungselement 116 an den Enden der Leiterelemente verbunden; das Set 115c ist mit einem Verbindungselement 117 verbunden, und das Set 115d ist mit einem Verbindungselement 118 verbunden. Zwischen den Verbindungselementen 117 und 118 ist auch hier eine als Chip oder Trimmer ausgestaltete Kapazität 119 eingebaut, um die Resonanzfrequenz des Resonators einstellen zu können. Hierbei funktioniert die Homogenisierung der Ströme über einen bestimmten Bereich der Kapazität 119 (Frequenzbereich des Resonators). Die Anpassung der Ströme in den einzelnen Beinen erfolgt durch kapazitive Anpassung. Hier wurden erneut nur aus Gründen der Vereinfachung der Simulationsrechnung die Längen angepasst, anstatt das Verhältnis Leiterbahnbreite zu Leiterbahnabstand anzupassen. Die Sets von Leiterelementen links, 115a/c, und rechts, 115b/d, wurden oben und unten zusammengeschaltet. Dies muss nicht so sein. Es kann auch nur am Anschlussbein der Kapazität 119 mittels der Verbindungselemente 117, 118 zusammengeschaltet werden und die Leiterbahnen oben können ohne galvanische Verbindung weitergezogen werden. In diesem Falle müssen allerdings die Kopplungen zwischen den Leiterelementen neu angepasst werden.

### e.) Ausführungsformen von Birdcage-Resonatoren

Die Erfindung lässt sich auch auf andere Spulentypen anwenden: z.B. auf die Hybrid-Spule gemäß [9].

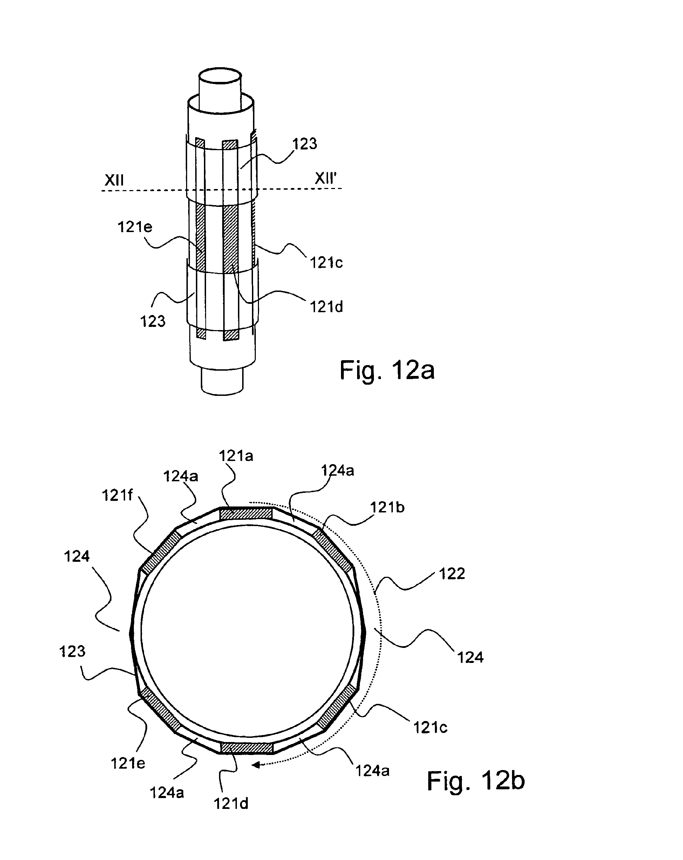

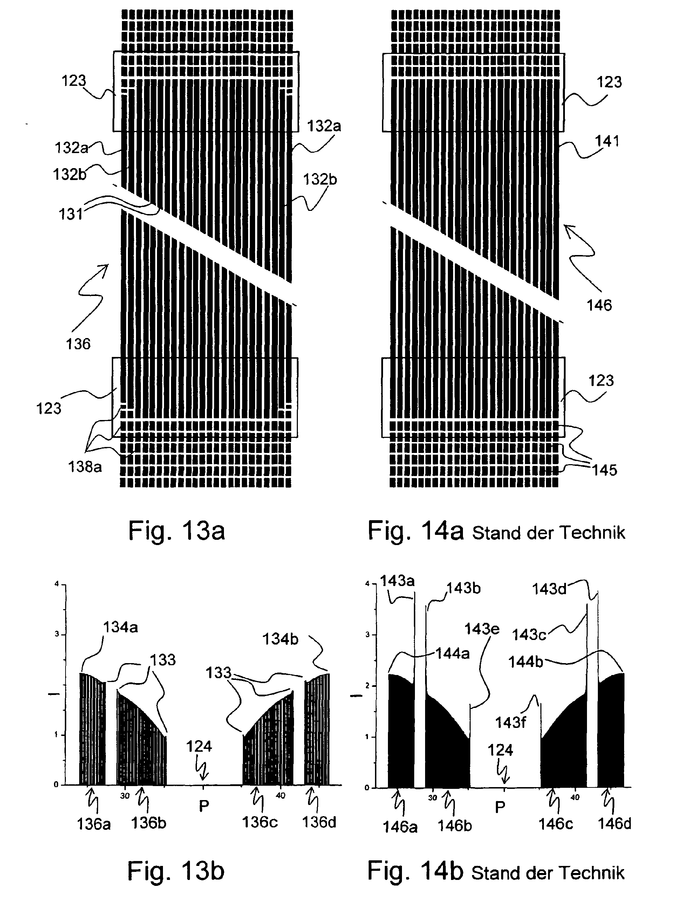

**Fig. 12a** zeigt beispielhaft einen Hybrid-Birdcage-Resonator in einer perspektivischen Ansicht. Dieser Resonator weist insgesamt sechs Stangen auf, von denen drei Stangen 121 c, 121 d, 121 e in Fig. 12a sichtbar sind. Die Stangen bestehen jeweils aus mehreren geraden, parallel ausgerichteten Leiterelementen. Zur Vereinfachung sind die einzelnen Leiterelemente der Stangen 121c-121e in Fig. 12a nicht einzeln dargestellt, sondern es ist nur deren Bereich markiert. Die Stangen 121c-121e werden von zwei Metallfolien 123 überlappt. In der **Fig. 12b** ist eine Schnittdarstellung entlang der Ebene XII-XII' von Fig. 12a gezeigt. Die sechs Stangen 121a-121f und zwei Fenster 124 sind alle regelmäßig um das Zentrum des Hybrid-Birdcage-Resonators angeordnet. Der Pfeil 122 zeigt die Darstellungsrichtung einer Ortskoordinate P in den Figuren 13b/14b, in denen die Verteilung der Amplituden der maximalen Wechselströme in den Leiterelementen im Betrieb eines erfindungsgemäßen Birdcage-Resonators (Fig. 13b) und eines Birdcage-Resonators gemäß Stand der Technik (Fig. 14b) dargestellt ist. Grundsätzlich können auch die Zwischenräume 124a zwischen benachbarten Stangen 121a-121f als weitere kleine Fenster angesehen werden.

Die Stangen sind in den Figuren **13a****/b** für den erfindungsgemäßen Birdcage-Resonator und **14a/b** für einen Birdcage-Resonators des Standes der Technik näher beschrieben. Die Stangen 136, 146 bestehen aus einer Vielzahl von geraden, näherungsweise in einer Ebene liegenden, parallel ausgerichteten Leiterelementen 131, 132a, 132b, 141 (Die Darstellung der Leiterelemente 131, 132a, 132b, 141 ist in der Mitte unterbrochen, um die Übersichtlichkeit zu erhöhen). Die Leiterelemente 131, 132a, 132b, 141 werden oben und unten mit galvanisch isolierten Plättchen 138a, 145 fortgesetzt, um die Magnetisierungseffekte so gering wie möglich zu halten [9,10]). Die Leiterelemente 131, 132a, 132b, 141 sind aus HTS-Material gefertigt und sind hier auf ein Substrat aufgebracht, das zugleich als Dielektrikum dient. Die Leiterelemente befinden sich in Fig. 12b auf der Innenseite der Stangen 121a-121f, so dass kein galvanischer Kontakt der Leiterelemente mit der Metallfolie 123 gebildet wird.

Im Stand der Technik (**Fig. 14a**) weisen die Leiterelemente 141 eine identische Länge auf und werden an den Enden von Metallfolien 123 überlappt, die durch ein Dielektrikum beabstandet sind, wodurch Kapazitäten gebildet werden, die für alle Leiterelemente 141 identisch sind. Im Bereich der Enden der Leiterelemente 141 sind galvanisch isolierte Plättchen 145 angeordnet, die eine makroskopisch homogene Verteilung von Supraleitermaterial gemäß [10] bewirken. Mehrere Stangen 146, die mittels Metallfolie 123 oder metallischem Ring zusammengesetzt sind, bilden einen Hybrid-Birdcage-Resonator.

Bei diesem Hybrid-Birdcage-Resonator des Standes der Technik ist die globale Stromverteilung über die Stangen des Birdcages näherungsweise sinusoidal, vgl. **Fig. 14b**, die die Ströme in vier Stangen 146a-146d symmetrisch zu einem der Fenster 124 für den Fall des Birdcage-Resonators mit sechs Stangen zeigt. Die Ortskoordinate P entspricht dem Pfeil 122 in Fig. 12b; die in Fig. 14b äußeren Stangen 146a, 146d, entsprechend 121a, 121d in Fig. 12b, sind dabei nur zur Hälfte dargestellt. Allerdings ist der Strom an den Kanten der Stangen 146a-146d wesentlich höher als zum Zentrum der Stangen 146a-146d hin. An den Positionen 143a - 143d liegt die Stromstärke oberhalb der Stromstärke der Maxima 144a, 144b der sinusförmigen Stromverteilung im Resonator. An diesen Positionen 143a-143d liegen somit spitzenförmige Stromüberhöhungen vor, die bei hoher Belastung des Resonators zu einem vorzeitigen lokalen Quench führen können. Weitere Stromspitzen mit einer geringeren Amplitude als die der Maxima 144a, 144b liegen an den Positionen 143e und 143f vor.

Bei einer erfindungsgemäßen Birdcage-Resonatorspule, vgl. die Darstellung einer entsprechenden Stange 136 in **Fig. 13a**, ist jede Stange in viele Leiterelemente 131, 132a, 132b unterteilt; die Stange 136 bildet somit ein Set von Leiterelementen. Die Leiterelemente 131, 132a, 132b sind von mittels Dielektrika beabstandeten Metallfolien 123 überlappt. Im Bereich der Enden der Leiterelemente 131, 132a, 132b sind wiederum galvanisch isolierte Plättchen 138a zur makroskopischen Homogenisierung des Supraleitermaterials vorgesehen, vgl. [10]. Die Kapazität, die zwischen den einzelnen Leiterelemente 131, 132a, 132b und der Metallfolie 123 gebildet wird, ist hier so angepasst, dass die Stromverteilung global sinusförmig ist, d.h. die spitzenförmigen Stromüberhöhungen sind eliminiert. Dies führt auch zu verbesserter Homogenität des B1-Feldes. Die Anpassung erfolgt in diesem Beispiel über eine Verkürzung der äußeren, d.h. randständigen Leiterelemente 132a, 132b gegenüber den weiter innen liegenden Leiterelementen 131, die eine einheitliche Länge aufweisen. Die Verkürzung ist dabei bei den weiter außen liegenden Leiterelementen 132a stärker ausgeprägt als bei den weiter innen liegenden Leiterelementen 132b. Im gezeigten Fall sind lediglich die jeweils beiden äußeren Leiterelemente 132a, 132b verkürzt. Bei mehr Leiterelementen in der Stange (d.h. bei einem größerem Paket von Leiterelementen) können auch größere Gruppen von Leiterelementen verkürzt sein. Alternativ kann auch die Breite der Leiterelemente 131,132a, 132b verändert werden, ebenso wie die Schichtdicke oder das Material des Kapazitätsbildenden Dielektrikums.

Durch die erfindungsgemäße Kapazitätsanpassung werden die an den Randpositionen der Stangen auftretenden Strommaxima 133 abgeschwächt, vgl. die Stromverteilung in **Fig. 13b** auf den vier Stangen 136a-136d (entsprechend 121a-121d in Fig. 12b) symmetrisch zu einem der beiden großen Fenster 124 eines erfindungsgemäßen Birdcage-Resonators mit insgesamt sechs Stangen. Insbesondere sind die Beträge der Strommaxima 133 kleiner als die Beträge der Stromstärken der Maxima 134a, 134b der sinusförmigen Soll-Stromverteilung.

Alternativ kann erfindungsgemäß der Strom über alle Leiterbahnen eines Birdcage-Resonators (auf jeder Stange oder auf allen Stangen) gleichverteilt eingestellt werden, was zur höchsten Stromtragefähigkeit führen würde aber die B1-Homogenität der Spule reduzieren würde.

### f.) Homogenisierung des B1-Feldes

Als weitere Nebenbedingung der Auslegung der Stromdichten in den Leiterelementen eines HF-Resonators kann ein homogenes B1-Feld eingeführt werden.

Während in den zuvor beschriebenen erfindungsgemäßen Anordnungen eine hohe Dichte von Leiterbahnen bzw. Leiterelementen in gewissem Maße als Nebenbedingung berücksichtigt wurde, kann diese Nebenbedingung durch die Nebenbedingung der hohen B1-Feldhomogenität ersetzt werden.

Da im Allgemeinen HF-Ströme im Außenbereich der Leiterelemente fließen, ist es vorteilhaft, Leiterelemente mit kleinem Querschnitt zu verwenden, um eine Verfälschung des Magnetfelds durch lokale Stromverteilungen im Leiterelement gering zu halten. Die Leiterelemente können dann in Berechnungen als linienförmig angenommen werden.

Eine Anordnung von Resonatoren wie in **Fig. 15c** gezeigt, kann leicht mit verbesserter Feldhomogenität ausgestattet werden. Die Resonatorpaare 151, 152 und 153, welche um die zu vermessende Probe 154 angeordnet sind, können dann erfindungsgemäß entsprechend **Figur 15a/15b** ausgestaltet sein. Um maximale Feldhomogenität in der x-y Ebene zu erreichen, muss man mehr Strom außen als innen in einem Resonator haben. Bei gleich großen Strömen in jedem Leiterelement wird erfindungsgemäß die Dichte der Leiterelemente nach außen hin, d. h. von der Probe weg, erhöht.

### g.) Zusammenfassende Würdigung

Um bei HF-Resonatoren ein höheres HF-Magnetfeld und damit einen größeren Gesamtstrom im HF-Resonator handhaben zu können, werden erfindungsgemäß die Leiterelemente, aus denen sich der HF-Resonator zusammensetzt, so gewählt und angeordnet, dass die maximale Stromdichte, die in einem Betriebszustand entlang eines beliebigen Leiterelements auftritt, dividiert durch die maximal verträgliche Stromdichte am Ort der maximalen Stromdichte in diesem Leiterelement im Wesentlichen einen bestimmten Sollwert einnimmt, der für alle Leiterelemente im HF-Resonator gleich ist. Für wenige Leiterelemente insbesondere im Randbereich des HF-Resonators kann auch ein reduzierter Sollwert vorgesehen sein. Alternativ wird bei HF-Resonatoren, bei denen eine bestimmte Soll-Stromverteilung in typischerweise gleichartigen Leiterelementen vorgesehen ist, durch erfindungsgemäße Auswahl und Anordnung der Leiterelemente gewährleistet, dass der Stromfluss in jedem beliebigen Leiterelement maximal so groß ist wie der Stromfluss in demjenigen Leiterelement mit der höchsten Stromstärke gemäß Soll-Stromverteilung. Dadurch werden lokale, spitzenförmige Stromüberhöhungen, wie sie etwa am Rand von Stangen bei Birdcage-Resonatoren auftreten können, vermieden.

Bei erfindungsgemäßen supraleitenden Resonatoren kann ein vorzeitiger lokaler Quench von einzelnen Leiterelementen vermieden, sowie der lineare Bereich der Widerstandskennlinie wesentlich erweitert werden, und bei erfindungsgemäßen normalleitenden Resonatoren bewirkt die gleichmäßigere Stromdichteverteilung eine höheren Resonatorgüte (Q-Wert).

### Literaturliste

[1] Wong et al. US 6590394 B2 07/03
[2] Withers US 6556013 B2 04/03
[3] Brey et al. US 5619140 A 04/97
[4] Brey et al. US 5594342 A 01/97
[5] Withers US 5585723 A 12/96
[6] Brey et al US 5565778 A 10/96
[7] Withers et al. US 5351007 A 9/94
[8] Withers et al. US5276398 01/94
[9] Marek DE19733574 A1 02/99
[10] Marek DE10150131 A1 04/03

## Patentansprüche

1. Hochfrequenz(=HF)-Resonator-System, insbesondere für einen NMR(=Kernspinresonanz)-Probenkopf, mit mindestens einem HF-Resonator, der mindestens drei Einzelresonatoren umfasst, die jeweils als nicht unterbrochene Leiterelemente (21; 54, 56, 58; 75, 76; 91-94; 111a-111d; 169a-169f) ausgebildet sind, wobei die Leiterelemente (21; 54, 56, 58; 75, 76; 91-94; 111a-111d; 169a-169f) im HF-Resonator mindestens ein Fenster (57; 77a) bilden, wobei nur ein Teil der Leiterelemente das mindestens eine Fenster (57; 77a) begrenzt, wobei die Leiterelemente durch elektromagnetische Felder miteinander gekoppelt sind, wobei jedes Leiterelement (21; 54, 56, 58; 75, 76; 91-94; 111a-111d; 169a-169f) jeweils eine materialbedingte, entlang des Leiterelements (21; 54, 56, 58; 75, 76; 91-94; 111a-111d; 169a-169f) ortsabhängige Grenzstromdichte aufweist, die im Betrieb nicht überschritten werden darf,
**dadurch gekennzeichnet,**
**dass** die Eigenresonanzen der einzelnen Leiterelemente (21; 54, 56, 58; 75, 76; 91-94; 111a-111d; 131, 169a-169f) und/oder die elektromagnetische Kopplung zwischen den Leiterelementen (21; 54, 56, 58; 75, 76; 91-94; 111a-111d; 169a-169f) durch eine geeignete Geometrie so gewählt sind,
**dass** bei Anregung des HF-Resonator-Systems die Maximalwerte der Quotientenwerte entlang den einzelnen Leiterelementen (21; 54, 56, 58; 75, 76; 91-94; 111a-111d; 169a-169f) für alle Leiterelemente (21; 54, 56, 58; 75, 76; 91-94; 111a-111d; 169a-169f) im Wesentlichen gleich sind, wobei diese Quotientenwerte durch den Quotienten aus der in einem Querschnitt der Leiterelemente (21; 54, 56, 58; 75, 76; 91-94; 111a-111d; 169a-169f) senkrecht zur Stromflussrichtung auftretenden mittleren Stromdichte und der jeweiligen örtlichen Grenzstromdichte definiert sind, wobei die Maximalwerte der Quotientenwerte im Wesentlichen gleich sind, wenn die Abweichung eines jeden Maximalwerts vom Mittelwert der Maximalwerte der einzelnen Leiterelemente maximal 25%, vorzugsweise maximal 10%, beträgt.

2. Hochfrequenz(=HF)-Resonator-System, insbesondere für einen NMR(=Kernspinresonanz)-Probenkopf, mit mindestens einem HF-Resonator, der mindestens drei Einzelresonatoren umfasst, die jeweils als nicht unterbrochene Leiterelemente (131, 132a-132b) ausgebildet sind, wobei die Leiterelemente (131, 132a-132b) im HF-Resonator mindestens ein Fenster (124, 124a) bilden, wobei nur ein Teil der Leiterelemente das mindestens eine Fenster (124, 124a) begrenzt, wobei die Leiterelemente durch elektromagnetische Felder miteinander gekoppelt sind, wobei jedes Leiterelement (131, 132a-132b) jeweils eine materialbedingte, entlang des Leiterelements (131, 132a-132b) ortsabhängige Grenzstromdichte aufweist, die im Betrieb nicht überschritten werden darf,
**dadurch gekennzeichnet,**
**dass** der HF-Resonator als Birdcage-Resonator, insbesondere Hybrid-Birdcage-Resonator ausgebildet ist und mehrere Stangen (121a-121f; 136; 136a-136d) von geraden, parallelen Leiterelementen (131, 132a, 132b) umfasst,
**dass** die Leiterelemente (131, 132a, 132b) an den Enden von mittels Dielektrika beabstandeten Metallfolien (123) überlappt werden,
**dass** in einem mittleren Bereich der Stangen (121a-121f; 136; 136a-136d) die Leiterelemente (131) jeweils gleich lang sind,
und **dass** in außen liegenden Bereichen der Stangen (121a-121f; 136; 136a-136d) weiter außen liegende Leiterelemente (132a) gegenüber weiter innen liegenden Leiterelementen (132b) verkürzt sind,
so dass die Eigenresonanzen der einzelnen Leiterelemente (131, 132a-132b) und/oder die elektromagnetische Kopplung zwischen den Leiterelementen (131, 132a-132b) so gewählt sind,
**dass** der Maximalwert der Quotientenwerte entlang eines jeden Leiterelements (131, 132a, 132b) kleiner oder gleich ist dem Maximalwert in demjenigen Leiterelement (131, 132a, 132b) mit dem gemäß Soll-Stromverteilung größten Maximalwert der Quotientenwerte, wobei diese Quotientenwerte durch den Quotienten aus der in einem Querschnitt der Leiterelemente (131, 132a-132b) senkrecht zur Stromflussrichtung auftretenden mittleren Stromdichte und der jeweiligen örtlichen Grenzstromdichte definiert sind,
so dass bei Anregung des Resonator-Systems in Hinblick auf eine vorgesehene, relative Soll-Stromverteilung in den einzelnen Leiterelementen (131, 132a, 132b) spitzenförmige Stromüberhöhungen (143a-143f), die vorwiegend im Randbereich der Stangen (131, 132a, 132b), insbesondere am Rand des mindestens einen Fensters (124, 124a), entlang einzelner Leiterelemente (132a, 132b) oder entlang Leitergruppen aus mehreren Leiterelementen (132a, 132b) vorkommen können, eliminiert werden.

3. HF-Resonator-System nach Anspruch 1 oder 2, **dadurch gekennzeichnet, dass** die Leiterelemente (21; 54, 56, 58; 75, 76; 91-94; 111a-111d; 131, 132a-132b; 169a-169f) aus Supraleitermaterial, insbesondere NbTi oder Nb₃Sn, gefertigt sind.

4. HF-Resonator-System nach Anspruch 3, **dadurch gekennzeichnet, dass** die Leiterelemente (21; 54, 56, 58; 75, 76; 91-94; 111a-111d; 131, 132a-132b; 169a-169f) aus Hochtemperatur-Supraleitermaterial mit einer Sprungtemperatur > 30 K gefertigt sind.

5. HF-Resonator-System nach einem der vorhergehenden Ansprüche,
**dadurch gekennzeichnet, dass** die Leiterelemente (21; 54, 56, 58; 75, 76; 91-94; 111a-111d; 131, 132a-132b; 169a-169f) auf einem ebenen, polyedrischen oder zylinderförmigen, dielektrischen Substrat aufgebracht sind.

6. HF-Resonator-System nach einem der vorhergehenden Ansprüche,
**dadurch gekennzeichnet, dass** die Leiterelemente (21; 54, 56, 58; 75, 76; 91-94; 111a-111d; 131, 132a-132b; 169a-169f) einen annähernd rechteckförmigen Querschnitt aufweisen, insbesondere mit einer Dicke zwischen 200 nm und 1 µm und/oder einer Breite zwischen 2 µm und 50µm.

7. HF-Resonator-System nach einem der vorhergehenden Ansprüche,
**dadurch gekennzeichnet, dass** die Grenzstromdichten in allen Leiterelementen (21; 54, 56, 58; 75, 76; 91-94; 111 a-111 d; 131, 132a-132b; 169a-169f) eines HF-Resonators gleich groß sind.

8. HF-Resonator-System nach einem der vorhergehenden Ansprüche,
**dadurch gekennzeichnet, dass** die Leiterelemente (21; 54, 56, 58; 75, 76; 91-94; 111a-111d; 131, 132a-132b; 169a-169f) eines HF-Resonators am Ort ihrer jeweiligen maximalen Quotientenwerte jeweils identische Querschnitte aufweisen.

9. HF-Resonator-System nach einem der vorhergehenden Ansprüche,
**dadurch gekennzeichnet, dass** ein oder mehrere Leiterelemente (21; 54, 56; 75, 76; 91-94; 111a-111d; 131, 132a-132b; 169a-169f) einen mäanderförmigen Abschnitt (101, 102) aufweisen, insbesondere wobei der mäanderförmige Abschnitt im Bereich der Basis eines U-förmigen Leiterelements (111 a, 111 c, 111 d) angeordnet ist.

10. HF-Resonator-System nach einem der Ansprüche 1 bis 8, **dadurch gekennzeichnet, dass** verschiedene Leiterpaare unterschiedliche kapazitive Überlappungen besitzen.

11. HF-Resonator-System nach einem der Ansprüche 1 bis 8, **dadurch gekennzeichnet, dass** das Verhältnis zwischen Breite und Abstand für verschiedene Leiterpaare unterschiedlich ist.

12. HF-Resonator-System nach einem der Ansprüche 1 und 3-11, sofern er nicht von Anspruch 2 abhängt, **dadurch gekennzeichnet, dass** der HF-Resonator vier Sets (71-74) von ineinander geschachtelten U-förmigen Leiterelementen (75, 76) umfasst, wobei die U-förmigen Leiterelemente eines jeden Sets (71-74) in eine gleiche Richtung zum Zentrum (77) des HF-Resonators hin geöffnet sind,
dass innerhalb jedes Sets (71-74) bei weiter außen liegenden U-förmigen Leiterelementen die Enden der Schenkel gegenüber den Enden der Schenkel von weiter innen liegenden U-förmigen Leiterelementen zurückgesetzt sind,
dass jeweils zwei Sets (71, 72; 73, 74) mit den Öffnungsrichtungen ihrer U-förmigen Leiterelemente aufeinander zu zeigen und in einer Ebene angeordnet sind, wobei die U-förmigen Leiterelemente der beiden Sets (71, 72; 73, 74) einer jeden Ebene nicht ineinander greifen,
und wobei die Öffnungsrichtungen der U-förmigen Leiterelemente der ersten Ebene gegenüber den Öffnungsrichtungen der U-förmigen Leiterelemente der zweiten Ebene um 90° gedreht sind.

13. HF-Resonator-System nach Anspruch 12, **dadurch gekennzeichnet, dass** die beiden Ebenen parallel benachbart angeordnet und durch eine dielektrische Schicht miteinander verbunden sind.

14. HF-Resonator-System nach einem der Ansprüche 1 und 3-11, sofern er nicht von Anspruch 2 abhängt, **dadurch gekennzeichnet, dass** der HF-Resonator zwei Sets (51, 52) von U-förmigen Leiterelementen (54, 56) umfasst, wobei die U-förmigen Leiterelemente jedes Sets (51, 52) jeweils ineinander geschachtelt und in eine gleiche Richtung geöffnet sind,
dass die Öffnungsrichtungen der U-förmigen Leiterelemente der beiden Sets (51, 52) aufeinander zu zeigen,
dass die Schenkel der U-förmigen Leiterelemente der beiden Sets (51, 52) ineinander greifen, wobei in jeden Zwischenraum zwischen zwei benachbarten Schenkeln von Leiterelementen eines Sets (51, 52) genau ein Schenkel eines Leiterelements des anderen Sets (52, 51) eingreift, und dass die Eingriffstiefe der Schenkel der U-förmigen Leiterelemente in die Zwischenräume im HF-Resonator in einem inneren Bereich (53), der an das Fenster (57) angrenzt, von innen nach außen abnimmt.

15. HF-Resonator-System nach Anspruch 14, **dadurch gekennzeichnet, dass** die Eingriffstiefe der Schenkel der U-förmigen Leiterelemente in die Zwischenräume im HF-Resonator in einem äußeren Bereich (55) von innen nach außen wieder zunimmt.

16. HF-Resonator-System nach einem der Ansprüche 1 und 3-15, sofern er nicht von Anspruch 2 abhängt,
**dadurch gekennzeichnet, dass** es mehrere baugleiche HF-Resonatoren, insbesondere 2 oder 4 baugleiche HF-Resonatoren umfasst.

17. NMK-Probenkopf mit einem HF-Resonator-System nach einem der vorhergehenden Ansprüche, welches eine zu messende Probe (154) aufweist, wobei die Leiterelemente auf einem Substrat gemäß Anspruch 5 platziert sind und die räumliche Anordnung der Leiterelemente so gewählt ist, dass das im aktiven Volumen der Probe (154) erzeugte HF-Magnetfeld möglichst homogen ist.

18. HF-Resonator-System, bzw. NMR-Probenkopf nach einem der vorhergehenden Ansprüche,
**dadurch gekennzeichnet, dass** benachbarte Leiterelemente (111a-111d; 169a-169f), des HF-Resonator-Systems galvanisch miteinander verbunden sind, insbesondere an Orten gleichen elektrischen Potentials.

19. Verfahren zum Design eines HF-Resonator-Systems mit homogener Stromauslastung nach Anspruch 1, umfassend folgende Schritte:
1. Auslegen eines beliebigen HF-Resonator-Systems;
2. Berechnung der Stromverteilung im HF-Resonator-System für die gewünschte Resonanz-Mode;
3. Rechnerische Bestimmung der Maximalwerte *Qᵢ* der Quotientenwerte entlang der einzelnen Leiterelemente *i*;
4. Korrektur der Eigenresonanzen der einzelnen Leiterelemente und/oder der elektromagnetischen Kopplung durch Anpassen der Längen, und/oder der Verhältnisse zwischen Abstand und Breite der kapazitiven Überlappungen zu benachbarten Leiterelementen, und/oder durch Ersetzen gerader durch mäanderförmige Leiterabschnitte, wobei diese Änderungen proportional zur jeweiligen Abweichung des in Schritt 3 berechneten Wertes Qᵢ von einem konstanten Referenzwert erfolgen, wobei der Referenzwert vorzugsweise gleich dem kleinsten, größten oder dem durchschnittlichen Wert der in Schritt 3 berechneten *Qᵢ*-Werte ist;
5. Wiederholen der Schritte 2 bis 4 solange, bis alle Werte Qᵢ im Wesentlichen gleich dem gewählten Referenzwert sind, und sich ein Hochfrequenz-Resonator-System gemäs Anspruch 1 ergibt.

20. Verfahren zum Design eines HF-Resonator-Systems ohne spitzenförmige Stromüberhöhungen nach Anspruch 2, umfassend folgende Schritte:
1. Auslegen eines beliebigen HF-Resonator-Systems;
2. Berechnung der Stromverteilung im HF-Resonator-System für die gewünschten Resonanz-Mode;
3. Rechnerische Bestimmung der Maximalwerte Qᵢ der Quotientenwerte entlang der einzelnen Leiterelemente i;
4. Selektion der Leiterelemente k in den Randbereichen, wo spitzenförmige Stromüberhöhungen auftreten, deren Maximalwerte der Quotientenwerte gleich *Qₖ* sind;
5. Korrektur der Eigenresonanzen der einzelnen Leiterelemente k und/oder der elektromagnetischen Kopplung durch Anpassen der Längen, und/oder der Verhältnisse zwischen Abstand und Breite der kapazitiven Überlappungen zu benachbarten Leiterelementen, und/oder durch Ersetzen gerader durch mäanderförmige Leiterabschnitte, wobei diese Änderungen proportional zur jeweiligen Abweichung des in Schritt 3 berechneten Wertes Qₖ von einem Referenzwert erfolgen, wobei der Referenzwert kleiner als der größte *Qᵢ*-Wert außerhalb der selektionierten Randbereiche ist;
6. Wiederholen der Schritte 2 bis 5 solange, bis alle Werte *Qₖ* kleiner oder gleich dem gewählten Referenzwert sind, und sich ein Hochfrequenz-Resonator-System gemäß Anspruch 2 ergibt.

## Claims

1. Radio-frequency (RF) resonator system, in particular for an NMR (nuclear magnetic resonance) probe head, with at least one RF resonator, which comprises at least three individual resonators, each being designed as non-interrupted conducting elements (21; 54, 56, 58; 75, 76; 91-94; 111a-111d; 169a-169f), wherein the conducting elements (21; 54, 56, 58; 75, 76; 91-94; 111a-111d; 169a-169f) form at least one window (57; 77a) in the RF resonator, with only a part of the conducting elements delimiting the at least one window (57; 77a), wherein the conducting elements are coupled to each other via electromagnetic fields, wherein each conducting element (21; 54, 56, 58; 75, 76; 91-94; 111a-111d; 169a-169f) has a limiting current density which is dependent on the position along the conducting element (21; 54, 56, 58; 75, 76; 91-94; 111a-111d; 169a-169f) and on the material, and which may not be exceeded during operation,
**characterized in that**
the self-resonances of the individual conducting elements (21; 54, 56, 58; 75, 76; 91-94; 111a-111d; 131, 169a-169f) and/or the electromagnetic coupling between the conducting elements (21; 54, 56, 58; 75, 76; 91-94; 111a-111d; 169a-169f) are selected by means of a suitable geometry such that, upon excitation of the RF resonator system, the maximum values of the quotient values along the individual conducting elements (21; 54, 56, 58; 75, 76; 91-94; 111a-111d; 169a-169f) are substantially equal for all conducting elements (21; 54, 56, 58; 75, 76; 91-94; 111a-111d; 169a-169f), wherein these quotient values are defined by a quotient of an average current density in a cross-section of the conducting elements (21; 54, 56, 58; 75, 76; 91-94; 111a-111d; 169a-169f) perpendicular to the direction of current flow and the respective local limiting current density, wherein the maximum values of the quotient values are substantially equal when the deviation of each maximum value from the average value of the maximum values of the individual conducting elements is maximally 25%, preferably maximally 10%.

2. Radio-frequency (RF) resonator system, in particular for an NMR (nuclear magnetic resonance) probe head, with at least one RF resonator which comprises at least three individual resonators, each being designed as non-interrupted conducting elements (131, 132a-132b), wherein the conducting elements (131, 132a-132b) form at least one window (124, 124a) in the RF resonator, with only a part of the conducting elements delimiting the at least one window (124, 124a), wherein the conducting elements are coupled to each other via electromagnetic fields, wherein each conducting element (131, 132a-132b) has a limiting current density which is dependent on the position along the conducting element (131, 132a-132b) and on the material, and which may not be exceeded during operation, **characterized in that**
the RF resonator is designed as Birdcage resonator, in particular as hybrid Birdcage resonator, and comprises several bars (121a-121f; 136; 136a-136d) of straight, parallel conducting elements (131, 132a, 132b),
the ends of the conducting elements (131, 132a, 132b) are overlapped by metal foils (123) spaced apart by means of dielectrics, that in a central region of the bars (121a-121f; 136; 136a-136d), each conducting element (131) has the same length,
and that in outer regions of the bars (121a-121f; 136; 136a-136d), the further outward conducting elements (132a) are shorter than the further inward conducting elements (132b) such that the self-resonances of the individual conducting elements (131, 132a-132b) and/or the electromagnetic coupling between the conducting elements (131, 132a-132b) are selected such that the maximum value of the quotient values along each individual conducting element (131, 132a; 132b) is smaller than or equal to the maximum value **in that** conducting element (131, 132a, 132b) with the largest maximum value of the quotient values in accordance with the nominal current distribution, wherein these quotient values are defined by a quotient of an average current density in a cross-section of the conducting elements (131, 132a-132b) perpendicular to the direction of current flow and the respective local limiting current density,
so that, upon excitation of the resonator system in view of an intended relative nominal current distribution in the individual conducting elements (131, 132a, 132b), peak-shaped current excesses (143a-143f), which may occur mainly in the edge region of bars (131, 132a, 132b), in particular at the edge of the at least one window (124, 124a), along individual conducting elements (132a, 132b) or along conductor groups of several conducting elements (132a, 132b), are eliminated.

3. RF resonator system according to claim 1 or 2, **characterized in that** the conducting elements (21; 54, 56, 58; 75, 76; 91-94; 111a-111d; 131, 132a-132b; 169a-169f) are produced from superconducting material, in particular NbTi or Nb₃Sn.

4. RF resonator system according to claim 3, **characterized in that** the conducting elements (21; 54, 56, 58; 75, 76; 91-94; 111a-111d; 131, 132a-132b; 169a-169f) are produced from high-temperature superconducting material with a transition temperature > 30K.

5. RF resonator system according to any one of the preceding claims, **characterized in that** the conducting elements (21; 54, 56, 58; 75, 76; 91-94; 111a-111d; 131, 132a-132b; 169a-169f) are disposed on a flat, polyhedral or cylindrical, dielectric substrate.

6. RF resonator system according to any one of the preceding claims, **characterized in that** the conducting elements (21; 54, 56, 58; 75, 76; 91-94; 111a-111d; 131, 132a-132b; 169a-169f) have an approximately rectangular cross-section, in particular, with a thickness of between 200nm and 1µm and/or width between 2µm and 50µm.

7. RF resonator system according to any one of the preceding claims, **characterized in that** the limiting current densities in all conducting elements (21; 54, 56, 58; 75, 76; 91-94; 111a-111d; 131, 132a-132b; 169a-169f) of an RF resonator are equal.

8. RF resonator system according to any one of the preceding claims, **characterized in that** the conducting elements (21; 54, 56, 58; 75, 76; 91-94; 111a-111d; 131, 132a-132b; 169a-169f) of an RF resonator each have identical cross-sections at a location of their respective maximum quotient values.

9. RF resonator system according to any one of the preceding claims, **characterized in that** one or more conducting elements (21; 54, 56; 75, 76; 91-94; 111a-111d; 131, 132a-132b; 169a-169f) comprise(s) a meandering section (101, 102), in particular, wherein the meandering section is disposed in the region of the base of a U-shaped conducting element (111a, 111c, 111d).

10. RF resonator system according to any one of the claims 1 through 8, **characterized in that** different conductor pairs have different capacitive overlappings.

11. RF resonator system according to any one of the claims 1 through 8, **characterized in that** the ratio between width and separation is different for different conductor pairs.

12. RF resonator system according to any one of the claims 1 and 3 through 11 unless dependent on claim 2, **characterized in that** the RF resonator comprises four sets (71-74) of nested U-shaped conducting elements (75, 76), wherein the U-shaped conducting elements of each set (71-74) are open in the same direction towards the center (77) of the RF resonator,
that within each set (71-74), the ends of the legs of further outward U-shaped conducting elements are recessed relative to the ends of the legs of further inward U-shaped conducting elements,
that the opening directions of the U-shaped conducting elements of two sets (71, 72; 73, 74) face one another and are disposed in one plane in each case, wherein the U-shaped conducting elements of the two sets (71, 72; 73, 74) of each plane do not engage,
and wherein the opening directions of the U-shaped conducting elements of the first plane are rotated by 90° relative to the opening directions of the U-shaped conducting elements of the second plane.

13. RF resonator system according to claim 12, **characterized in that** the two planes are disposed parallel and proximate to each other and are connected to each other by a dielectric layer.

14. RF resonator system according to any one of the claims 1 and 3 through 11 unless dependent on claim 2, **characterized in that** the RF resonator comprises two sets (51, 52) of U-shaped conducting elements (54, 56), wherein the U-shaped conducting elements of each set (51, 52) are nested and open towards the same direction, the opening directions of the U-shaped conducting elements of the two sets (51, 52) face each other,
the legs of the U-shaped conducting elements of the two sets (51, 52) engage each other, wherein exactly one leg of a conducting element of one set (52, 51) engages into each space between two neighboring legs of conducting elements of the other set (51, 52), and, in an inner region (53) which borders the window (57), the engagement depth of the legs of the U-shaped conducting elements into the spaces in the RF resonator decreases from the inside to the outside.

15. RF resonator system according to claim 14, **characterized in that**, in an outer region (55), the engagement depth of the legs of the U-shaped conducting elements into the spaces in the RF resonator increases again from the inside to the outside.

16. RF resonator system according to any one of the claims 1 and 3 through 15 unless dependent on claim 2, **characterized in that** it comprises several RF resonators of the same design, in particular 2 or 4 RF resonators of the same design.

17. NMR probe head comprising an RF resonator system according to any one of the preceding claims, the RF resonator system comprising a sample (154) to be measured, wherein the conducting elements are placed on a substrate according to claim 5, and the conducting elements are spatially arranged such that the RF magnetic field generated in the active volume of the sample (154) is as homogeneous as possible.

18. RF resonator system or NMR probe head according to any one of the preceding claims, **characterized in that** neighboring conducting elements (111a-111d; 169a-169f) of the RF resonator system are galvanically connected to each other, in particular, at locations having the same electric potential.

19. Method for designing an RF resonator system with homogeneous current utilization in accordance with claim 1, comprising the following steps:
1. designing any type of RF resonator system;
2. calculating the current distribution in the RF resonator system for the desired resonance mode;
3. calculating the maximum values Qᵢ of the quotient values along the individual conducting elements i;
4. correcting the self-resonances of the individual conducting elements and/or the electromagnetic coupling through adjustment of the lengths and/or the ratios between separation and width of the capacitive overlappings between neighboring conducting elements and/or through replacement of straight conducting sections by meandering conducting sections, wherein these changes are carried out in proportion to the respective deviation of the value Qᵢ, calculated in step 3, from a constant reference value, wherein the reference value is preferably equal to the minimum, maximum or average value of the Qᵢ values calculated in step 3;
5. repeating steps 2 through 4 until all values Qᵢ are substantially equal to the selected reference value and a radio frequency resonator system according to claim 1 is obtained.

20. Method for designing an RF resonator system without peak-shaped current excesses in accordance with claim 2, comprising the following steps:
1. designing any type of RF resonator system;
2. calculating the current distribution in the RF resonator system for the desired resonance mode;
3. calculating the maximum values Qᵢ of the quotient values along the individual conducting elements i;
4. selecting the conducting elements k in the edge regions with peak-shaped current excesses, whose maximum values of the quotient values are equal to Qₖ;
5. correcting the self-resonances of the individual conducting elements k and/or the electromagnetic coupling through adjustment of the lengths, and/or the ratios between separation and width of the capacitive overlappings between neighboring conducting elements and/or through replacement of straight conducting sections with meandering conducting sections, wherein these changes are carried out in proportion to the respective deviation of the value Qₖ, calculated in step 3, from a reference value, wherein the reference value is smaller than the maximum Qᵢ value outside of the selected edge regions;
6. repeating steps 2 through 5 until all values Qₖ are smaller than or equal to the selected reference value and a radio frequency resonator system according to claim 2 is obtained.

## Revendications

1. Système de résonateur haute fréquence (= HF), en particulier pour une tête de mesure de RMN (= résonance magnétique nucléaire), avec au moins un résonateur HF qui comprend au moins trois résonateurs individuels qui sont réalisés chacun sous la forme d'éléments conducteurs non interrompus (21 ; 54, 56, 58 ; 75, 76 ; 91-94 ; 111a-111d; 169a-169f), les éléments conducteurs (21 ; 54, 56, 58 ; 75, 76 ; 91-94 ; 111a- 111d ; 169a-169f) formant au moins une fenêtre (57 ; 77a) dans le résonateur HF, seulement une partie des éléments conducteurs délimitant ladite au moins une fenêtre (57 ; 77a), les éléments conducteurs étant couplés entre eux par des champs électromagnétiques, chaque élément conducteur (21 ; 54, 56, 58 ; 75, 76 ; 91-94 ; 111a-111d ; 169a-169f) présentant une densité de courant limite liée au matériau, dépendante de la position le long de l'élément conducteur (21 ; 54, 56, 58 ; 75, 76 ; 91-94 ; 111a-111d ; 169a-169f), qui ne doit pas être dépassée en fonctionnement,
**caractérisé en ce**
**que** les résonances propres des éléments conducteurs individuels (21 ; 54, 56, 58 ; 75, 76 ; 91-94 ; 111a-111d ; 169a-169f) et/ou le couplage électromagnétique entre les éléments conducteurs (21 ; 54, 56, 58 ; 75, 76 ; 91-94 ; 111a-111d; 169a-169f) sont choisis par une géométrie appropriée de façon
**que** lors de l'excitation du système de résonateur HF, les valeurs maximales des valeurs de quotient le long des éléments conducteurs individuels (21 ; 54, 56, 58 ; 75, 76 ; 91-94 ; 111a-111d ; 169a-169f) soient sensiblement égales pour tous les éléments conducteurs (21 ; 54, 56, 58 ; 75, 76 ; 91-94 ; 111a-111d ; 169a-169f), ces valeurs de quotient étant définies par le quotient de la densité de courant moyenne apparaissant perpendiculairement à la direction du flux de courant dans une section transversale des éléments conducteurs (21 ; 54, 56, 58 ; 75, 76 ; 91-94 ; 111a-111d ; 169a-169f) et de la densité de courant limite locale respective, les valeurs maximales des valeurs de quotient étant sensiblement égales lorsque l'écart de chaque valeur maximale par rapport à la valeur moyenne des valeurs maximales des éléments conducteurs individuels est au maximum de 25 %, de préférence au maximum de 10 %.

2. Système de résonateur HF, en particulier pour une tête de mesure de RMN (= résonance magnétique nucléaire), avec au moins un résonateur HF qui comprend au moins trois résonateurs individuels qui sont réalisés chacun sous la forme d'éléments conducteurs non interrompus (131, 132a-132b), les éléments conducteurs (131, 132a-132b) formant au moins une fenêtre (124, 124a) dans le résonateur HF, seulement une partie des éléments conducteurs délimitant ladite au moins une fenêtre (124, 124a), les éléments conducteurs étant couplés entre eux par des champs électromagnétiques, chaque élément conducteur (131, 132a-132b) présentant une densité de courant limite liée au matériau, dépendante de la position le long de l'élément conducteur (131, 132a-132b), qui ne doit pas être dépassée en fonctionnement,
**caractérisé en ce**
**que** le résonateur HF est réalisé sous la forme d'un résonateur en cage d'oiseau, en particulier d'un résonateur en cage d'oiseau hybride, et comprend plusieurs tiges (121a-121f; 136 ; 136a-136d) d'éléments conducteurs rectilignes parallèles (131, 132a, 132b),
**que** les éléments conducteurs (131, 132a, 132b) sont recouverts aux extrémités de feuilles métalliques (123) espacées au moyen de diélectriques,
**que** les éléments conducteurs (131) sont de même longueur dans une zone centrale des tiges (121a-121f; 136 ; 136a-136d),
et **que** dans des zones extérieures des tiges (121a-121f; 136; 136a-136d), des éléments conducteurs (132a) situés plus à l'extérieur sont raccourcis par rapport à des éléments conducteurs (132b) situés plus à l'intérieur,
de sorte que les résonances propres des éléments conducteurs individuels (131, 132a-132b) et/ou le couplage électromagnétique entre les éléments conducteurs (131, 132a-132b) sont choisis de façon
**que** la valeur maximale des valeurs de quotient le long de chaque élément conducteur (131, 132a, 132b) soit inférieure ou égale à la valeur maximale dans l'élément conducteur (131, 132a, 132b) ayant, selon la distribution de courant nominale, la plus grande valeur maximale des valeurs de quotient, ces valeurs de quotient étant définies par le quotient de la densité de courant moyenne apparaissant perpendiculairement à la direction du flux de courant dans une section transversale des éléments conducteurs (131, 132a-132b) et de la densité de courant limite locale respective,
de sorte que lors de l'excitation du système de résonateur par rapport à une distribution de courant nominale relative prévue dans les éléments conducteurs individuels (131, 132a, 132b), les augmentations de courant en forme de pointe (143a-143f) qui peuvent se produire principalement dans la zone de bord des tiges (131, 132a, 132b), en particulier au bord de ladite au moins une fenêtre (124, 124a), le long d'éléments conducteurs individuels (132a, 132b) ou le long de groupes de conducteurs composés de plusieurs éléments conducteurs (132a, 132b), sont éliminées.

3. Système de résonateur HF selon la revendication 1 ou 2, **caractérisé en ce que** les éléments conducteurs (21 ; 54, 56, 58 ; 75, 76 ; 91-94 ; 111a-111d ; 131, 132a-132b ; 169a-169f) sont réalisés en matériau supraconducteur, en particulier en NbTi ou Nb₃Sn.

4. Système de résonateur HF selon la revendication 3, **caractérisé en ce que** les éléments conducteurs (21 ; 54, 56, 58 ; 75, 76 ; 91-94 ; 111a-111d ; 131, 132a-132b ; 169a-169f) sont réalisés en matériau supraconducteur à haute température ayant une température de transition > 30 K.

5. Système de résonateur HF selon une des revendications précédentes, **caractérisé en ce que** les éléments conducteurs (21 ; 54, 56, 58 ; 75, 76 ; 91-94 ; 111a-111d ; 131, 132a-132b ; 169a-169f) sont appliqués sur un substrat diélectrique plan, polyédrique ou cylindrique.

6. Système de résonateur HF selon une des revendications précédentes, **caractérisé en ce que** les éléments conducteurs (21 ; 54, 56, 58 ; 75, 76 ; 91-94 ; 111a-111d ; 131, 132a-132b ; 169a-169f) présentent une section transversale approximativement rectangulaire, en particulier avec une épaisseur comprise entre 200 nm et 1 µm et/ou une largeur comprise entre 2 µm et 50 µm.

7. Système de résonateur HF selon une des revendications précédentes, **caractérisé en ce que** les densités de courant limites sont égales dans tous les éléments conducteurs (21 ; 54, 56, 58 ; 75, 76 ; 91-94 ; 111a-111d ; 131, 132a-132b ; 169a-169f) d'un résonateur HF.

8. Système de résonateur HF selon une des revendications précédentes, **caractérisé en ce que** les éléments conducteurs (21 ; 54, 56, 58 ; 75, 76 ; 91-94 ; 111a-111d ; 131, 132a-132b ; 169a-169f) d'un résonateur HF présentent des sections transversales identiques à l'endroit de leurs valeurs de quotient maximales respectives.

9. Système de résonateur HF selon une des revendications précédentes, **caractérisé en ce qu'**un ou plusieurs éléments conducteurs (21 ; 54, 56 ; 75, 76 ; 91-94 ; 111a-111d ; 131, 132a-132b; 169a-169f) présentent une partie en forme de méandres (101, 102), la partie en forme de méandres étant en particulier disposée dans la zone de la base d'un élément conducteur en forme de U (111a, 111c, 111d).

10. Système de résonateur HF selon une des revendications 1 à 8, **caractérisé en ce que** différentes paires de conducteurs possèdent des recouvrements capacitifs différents.

11. Système de résonateur HF selon une des revendications 1 à 8, **caractérisé en ce que** le rapport entre largeur et distance est différent pour différentes paires de conducteurs.

12. Système de résonateur HF selon une des revendications 1 et 3 à 11, pour autant qu'elle ne dépende pas de la revendication 2, **caractérisé en ce que** le résonateur HF comprend quatre ensembles (71-74) d'éléments conducteurs en forme de U (75, 76) emboîtés les uns dans les autres, les éléments conducteurs en forme de U de chaque ensemble (71-74) étant ouverts dans une même direction vers le centre (77) du résonateur HF,
qu'à l'intérieur de chaque ensemble (71-74), les extrémités des branches d'éléments conducteurs en forme de U situés plus à l'extérieur sont en retrait par rapport aux extrémités des branches d'éléments conducteurs en forme de U situés plus à l'intérieur,
que chaque fois deux ensembles (71, 72 ; 73, 74) sont dirigés l'un vers l'autre par les directions d'ouverture de leurs éléments conducteurs en forme de U et sont disposés dans un plan, les éléments conducteurs en forme de U des deux ensembles (71, 72 ; 73, 74) de chaque plan n'étant pas engagés les uns dans les autres,
et les directions d'ouverture des éléments conducteurs en forme de U du premier plan étant tournées de 90° par rapport aux directions d'ouverture des éléments conducteurs en forme de U du deuxième plan.

13. Système de résonateur HF selon la revendication 12, **caractérisé en ce que** les deux plans sont disposés parallèlement au voisinage l'un de l'autre et reliés entre eux par une couche diélectrique.

14. Système de résonateur HF selon une des revendications 1 et 3 à 11, pour autant qu'elle ne dépende pas de la revendication 2, **caractérisé en ce que** le résonateur HF comprend deux ensembles (51, 52) d'éléments conducteurs en forme de U (54, 56), les éléments conducteurs en forme de U de chaque ensemble (51, 52) étant emboîtés et ouverts dans une même direction,
que les directions d'ouverture des éléments conducteurs en forme de U des deux ensembles (51, 52) sont dirigées l'une vers l'autre,
que les branches des éléments conducteurs en forme de U des deux ensembles (51, 52) s'engagent les unes dans les autres, exactement une branche d'un élément conducteur d'un ensemble (51, 52) s'engageant dans chaque intervalle entre deux branches adjacentes d'éléments conducteurs de l'autre ensemble (52, 51),
et que la profondeur d'engagement des branches des éléments conducteurs en forme de U dans les intervalles diminue de l'intérieur vers l'extérieur du résonateur HF dans une zone intérieure (53) qui est adjacente à la fenêtre (57).

15. Système de résonateur HF selon la revendication 14, **caractérisé en ce que** la profondeur d'engagement des branches des éléments conducteurs en forme de U dans les intervalles augmente de nouveau de l'intérieur vers l'extérieur du résonateur HF dans une zone extérieure (55).

16. Système de résonateur HF selon une des revendications 1 et 3 à 11, pour autant qu'elle ne dépende pas de la revendication 2, **caractérisé en ce qu'**il comprend plusieurs résonateurs HF identiques, en particulier 2 ou 4 résonateurs HF identiques.

17. Tête de mesure de RMN avec un système de résonateur HF selon une des revendications précédentes, lequel présente un échantillon (154) à mesurer, les éléments conducteurs étant placés sur un substrat selon la revendication 5 et la disposition spatiale des éléments conducteurs étant choisie de façon que le champ magnétique HF produit dans le volume actif de l'échantillon (154) soit aussi homogène que possible.

18. Système de résonateur HF, respectivement tête de mesure de RMN, selon une des revendications précédentes, **caractérisé en ce que** des éléments conducteurs (111a-111d ; 169a-169f) adjacents du système de résonateur HF sont reliés entre eux galvaniquement, en particulier à des endroits de même potentiel électrique.

19. Procédé de conception d'un système de résonateur HF avec facteur de charge homogène selon la revendication 1, comprenant les étapes suivantes :
1. Conception d'un système de résonateur HF quelconque ;
2. Calcul de la distribution de courant dans le système de résonateur HF pour le mode de résonance souhaité ;
3. Détermination par calcul des valeurs maximales Qᵢ des valeurs de quotient le long des éléments conducteurs individuels i ;
4. Correction des résonances propres des éléments conducteurs individuels et/ou du couplage électromagnétique par adaptation des longueurs, et/ou des rapports entre distance et largeur des recouvrements capacitifs par rapport aux éléments conducteurs adjacents, et/ou par remplacement de parties de conducteurs rectilignes par des parties de conducteurs en forme de méandres, ces modifications étant proportionnelles à l'écart respectif de la valeur *Qᵢ* calculée à l'étape 3 avec une valeur de référence constante, la valeur de référence étant de préférence égale à la plus petite, la plus grande ou la valeur moyenne des valeurs Qᵢ calculées à l'étape 3 ;
5. Répétition des étapes 2 à 4 jusqu'à ce que toutes les valeurs Qᵢ soient sensiblement égales à la valeur de référence choisie et qu'il en résulte un système de résonateur haute fréquence selon la revendication 1.

20. Procédé de conception d'un système de résonateur HF sans augmentations de courant en forme de pointe selon la revendication 2, comprenant les étapes suivantes :
1. Conception d'un système de résonateur HF quelconque ;
2. Calcul de la distribution de courant dans le système de résonateur HF pour le mode de résonance souhaité ;
3. Détermination par calcul des valeurs maximales Qᵢ des valeurs de quotient le long des éléments conducteurs individuels i ;
4. Sélection des éléments conducteurs k dans les zones de bord où se produisent des augmentations de courant en forme de pointe dont les valeurs maximales sont égales aux valeurs de quotient *Qₖ ;*
5. Correction des résonances propres des éléments conducteurs individuels k et/ou du couplage électromagnétique par adaptation des longueurs, et/ou des rapports entre distance et largeur des recouvrements capacitifs par rapport aux éléments conducteurs adjacents, et/ou par remplacement de parties de conducteurs rectilignes par des parties de conducteurs en forme de méandres, ces modifications étant proportionnelles à l'écart respectif de la valeur *Qₖ* calculée à l'étape 3 avec une valeur de référence, la valeur de référence étant plus petite que la plus grande valeur Qᵢ à l'extérieur des zones de bord sélectionnées ;
6. Répétition des étapes 2 à 5 jusqu'à ce que toutes les valeurs Qₖ soient inférieures ou égales à la valeur de référence choisie et qu'il en résulte un système de résonateur haute fréquence selon la revendication 2.
